# EUROPÄISCHE PATENTSCHRIFT

(11) **EP 2 564 506 B1**
(45) Veröffentlichungstag und Bekanntmachung des Hinweises auf die Patenterteilung: **10.01.2018**
(21) Anmeldenummer: 11717271.8
(22) Anmeldetag: 02.05.2011
(51) Int. Cl.: H03K 19/0175

(54) **SCHNITTSTELLENSCHALTUNG UND VERFAHREN ZUR BEEINFLUSSUNG DER FLANKENSTEILHEIT EINES ANSTEUERSIGNALS**
INTERFACE CIRCUIT AND METHOD TO INFLUENCE THE EDGE SLOPE OF A CONTROL SIGNAL
CIRCUIT D'INTERFACE ET PROCÉDÉ POUR INFLUENCER LA PENTE D'UN SIGNAL D'EXCITATION

(30) Priorität: 30.04.2010 DE 102010028448
(43) Veröffentlichungstag der Anmeldung: 06.03.2013
(73) Patentinhaber: Tridonic GmbH & Co KG, 6851 Dornbirn (AT)
(72) Erfinder: BOECKLE, Reinhard, A-6841 Mäder (AT)
(74) Vertreter: Rupp, Christian
(86) Internationale Anmeldenummer: PCT/EP2011/056930
(87) Internationale Veröffentlichungsnummer: WO 2011/135097

(56) Entgegenhaltungen:
- US-A1- 2006 294 275
- US-A1- 2007 046 330

## Beschreibung

Die vorliegende Erfindung bezieht sich allgemein auf das Gebiet der Schnittstellenschaltungen insbesondere für Betriebsgeräte für Leuchtmittel. Die Schnittstellen übertragen Signale, die durch abrupte Spannungspegeländerungen ("Flanken") codiert sind.

Die vorliegende Erfindung bezieht sich insbesondere auf eine Schnittstellenschaltung mit wenigstens einem Sendezweig (und optional auch einem Empfangszweig), mit der im Sendebetrieb selektiv eine Flanke einer ersten Flankenrichtung (ansteigend bzw. abfallend) eines Ansteuersignals verlangsamt, also im zeitlichen Mittel abgeflacht, werden kann, während Flanken einer zweiten Flankenrichtung im Wesentlichen unbeeinflusst bleiben. Allgemein können solche Schnittstellenschaltungen häufig dort Verwendung finden, wo unterschiedliche elektronische Schaltanordnungen, beispielsweise über ein Bussystem oder Signalleitungen verbunden sind und die Flanken der Signale bestimmten Anforderungen bezüglich einer Signalanstiegszeit und einer Signalabfallszeit erfüllen sollten. Diese Anforderungen können beispielsweise in entsprechenden Spezifikationen und Normen des jeweiligen elektronischen oder mikroelektronischen Systems festgelegt sein. Insbesondere bezieht sich die Erfindung auf eine Schnittstellenschaltung für ein elektronisches Vorschaltgerät zum Betreiben eines Leuchtmittels, wobei das elektronische Vorschaltgerät über die Schnittstellenschaltung mit einem Bus- oder Leitungssystem verbunden werden kann, so dass zwischen dem elektronischen Vorschaltgerät und einer zentralen Steuereinheit eines Beleuchtungssystems Daten und/oder Steuerbefehle ausgetauscht werden können.

Bei dem Beleuchtungssystem kann es sich beispielsweise um ein sogenanntes Digital-Adressierbares-Licht-Schnittstellen (Digital-Addressable-Lighting-Interface = DALI)- System handeln. In diesem DALI-Beleuchtungssystem werden Daten, beispielsweise mit einem elektronischen Vorschaltgerät für Leuchtmittel, gemäß einem genormten Datenübertragungsprotokoll - dem DALI-Protokoll - ausgetauscht. Bei dieser digitalen Übertragung von Daten und/oder Steuerbefehlen werden an die entsprechenden fallenden und steigenden Flanken der Signale bestimmte Anforderungen bezüglich der Flankensteilheit gestellt. Mit bisherigen Schnittstellenschaltungen ist es jedoch nicht möglich, auf die fallende und steigende Flanke eines solchen Bussignals getrennt Einfluss zu nehmen. Üblicherweise lässt sich die gewünschte Flankensteilheit der entsprechenden Bussignale nur halbwegs durch Auswahl bestimmter Bauteile für die Schnittstellenschaltung und/oder eine entsprechende Dimensionierung der Bauteile im Toleranzbereich der im DALI-Standard geforderten Anstiegs- und Abfallzeiten halten. Die fallende Flanke des erzeugten Bussignals ist in solchen Schaltungen typischerweise relativ steil, während die steigende Flanke des Bussignals oftmals zu flach ist.

Eine fallende Flanke im DALI-Bussystem kann bedeuten, dass am Eingang einer Schnittstellenschaltung, welche an das Bussystem gekoppelt ist, eine Spannung von einem Hoch-Spannungspegel, von z. B. 16V, auf einen Niedrig-Spannungspegel, von z.B. 3V, gezogen wird. Grundsätzlich funktioniert in einem DALI-System die Signal- bzw. Daten- und Steuerbefehlübertragung so, dass im Falle eines Sendens eines Bits eine Spannung auf dem Bus durch einen niederohmigen Strompfad auf einem niedrigen Wert, also z. B. auf ein Massepotential, gezogen wird, während im Ruhezustand an dem Bussystem eine Spannung von beispielsweise 9,5 bis 22,5V anliegt. Im DALI-System werden die Daten also in einer sogenannten Aktiv-Niedrigpegel Übertragung (Active-Low Übertragung) übermittelt. Eine logische Null bzw. ein Niedrig-(Low)-Pegel kann dabei durch einem Spannungspegel zwischen - 4,5 V bis +4,5 V repräsentiert werden, während ein Spannungspegel zwischen +9,5 V bis +22,5 V oder zwischen -9,5 V bis - 22,5 V einem Hoch (High)-Pegel bzw. einer logischen Eins zugeordnet sein kann. Damit diese logischen Signale klar von allen elektronischen Geräten am Bussystem erkannt werden können, bestehen an die jeweiligen ansteigenden und abfallenden Flanken der Signale bestimmte Anforderungen.

Als Stand der Technik sind beispielsweise Schaltungsanordnungen bekannt, wie sie in den Dokumenten US 2006/294275 A1 und US 2007/046330 A1 beschrieben sind.

Aufgabe der vorliegenden Erfindung ist es, eine Schnittstellenschaltung zu schaffen, die es ermöglicht, Anforderungen an die Flankensteilheit von Signalen mit moderatem schaltungstechnischem Aufwand besser einzuhalten.

Diese Aufgabe wird durch die erfindungsgemäße Schnittstellenschaltung gemäß Anspruch 1, durch ein Betriebsgerät gemäß Anspruch 17, das Beleuchtungssystem nach Anspruch 18 und das Verfahren zur Beeinflussung der Flankensteilheit eines Ansteuersignals gemäß Anspruch 20 gelöst.

Durch die Schnittstellenschaltung gemäß Anspruch 1 kann im Sendebetrieb der Schnittstellenschaltung die Flankensteilheit von ansteigenden und abfallenden Flanken eines Signals unterschiedlich, also unabhängig voneinander beeinflusst werden, so dass mit moderatem schaltungstechnischem Aufwand die Anforderungen an die Flankensteilheit besser eingehalten werden können. Die Idee besteht dabei darin, dass mit einer Teil schaltung selektiv nur Einfluss auf die Flankensteilheit einer Flankenrichtung (ansteigend oder abfallend) genommen wird.

In Ausführungsbeispielen der vorliegenden Erfindung kann gezielt eine Flanke einer ersten Flankenrichtung eines Ansteuersignals im Sendezweig einer Schnittstellenschaltung verlangsamt werden. Damit kann also zumindest teilweise auf die ansteigende und fallende Flanke getrennt Einfluss genommen werden. In Ausführungsbeispielen kann dazu eine Flanken-Verlangsamungsschaltung in Abhängigkeit eines Steuersignals an eine steuerbare Schaltanordnung gekoppelt werden oder abhängig von dem Steuersignal auch entkoppelt werden, so dass einmal die Flanke einer ersten Flankenrichtung verlangsamt werden kann und einmal im Wesentlichen unbeeinflusst bleibt.

Vorteilhafte Weiterbildungen der Erfindung sind in den Unteransprüchen angegeben.

Bevorzugte Ausführungsbeispiele der Erfindung werden nachfolgend unter Bezugnahme auf die beiliegenden Zeichnungen näher erläutert. Es zeigen:
- Fig. 1: ein Blockschaltbild einer Schnittstellenschaltung mit einem Sendezweig gemäß einem Ausführungsbeispiel der vorliegenden Erfindung;
- Fig. 2: ein Blockschaltbild einer Schnittstellenschaltung mit Koppelschalter gemäß einem weiteren Ausführungsbeispiel der vorliegenden Erfindung;
- Fig. 3: ein Blockschaltbild einer Schnittstellenschaltung mit Darlingtonschaltung, Stromquelle, Gleichrichterschaltung, Optokoppler und einer Ansteuersignalformungsschaltung gemäß einem weiteren Ausführungsbeispiel der vorliegenden Erfindung;
- Fig. 4: einen Schaltplan einer Schnittstellenschaltung gemäß einem weiteren Ausführungsbeispiel der vorliegenden Erfindung;
- Fig. 5: einen Schaltplan einer spannungsfesten Schnittstellenschaltung gemäß einem weiteren Ausführungsbeispiel;
- Fig. 6: eine schematische Darstellung eines elektronischen Vorschaltgerätes für Leuchtmittel mit einer Schnittstellenschaltung gemäß einem Ausführungsbeispiel der vorliegenden Erfindung;
- Fig. 7a-b: eine schematische Darstellung eines Beleuchtungssystems mit einem elektrischen Vorschaltgerät, welches eine Schnittstellenschaltung gemäß einem Ausführungsbeispiel der vorliegenden Erfindung aufweist; und
- Fig. 8: ein Flussdiagramm für das Verfahren zur selektiven Beeinflussung der Flankensteilheit eines Ansteuersignals im Sendebetrieb gemäß einem Ausführungsbeispiel der vorliegenden Erfindung.

Bezüglich der nachfolgenden Beschreibung der Ausführungsbeispiele der vorliegenden Erfindung sollte beachtet werden, dass in den unterschiedlichen Figuren für funktional identische bzw. gleichwirkende oder funktionsgleiche äquivalente Elemente oder Schritte zur Vereinfachung in der gesamten Beschreibung die gleichen Bezugszeichen verwendet werden. Diese Elemente mit gleichen Bezugszeichen sind somit in den verschiedenen Ausführungsbeispielen untereinander austauschbar.

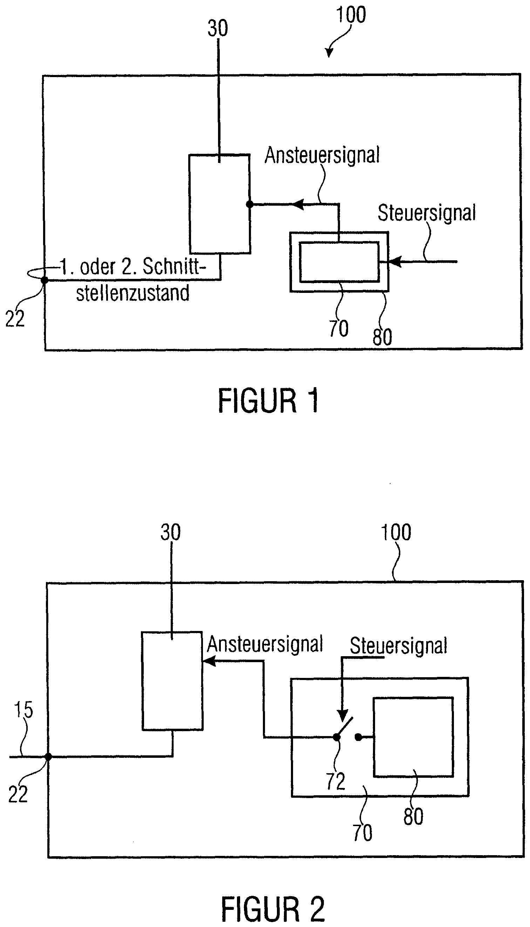

In Fig. 1 ist das Blockschaltbild einer Schnittstellenschaltung 100 gemäß einem Ausführungsbeispiel der vorliegenden Erfindung dargestellt. Die Schnittstellenschaltung 100 weist eine steuerbare Schaltanordnung 30 auf, die ausgelegt ist, um in Abhängigkeit von einem Ansteuersignal einen ersten Schnittstellenzustand oder einen zweiten Schnittstellenzustand zu bewirken.

Das Ansteuersignal wird bspw. von einem Controller eines der Schnittstelle zugeordneten Betriebsgeräts erzeugt, der somit das aussenden eines über die genannten Schnittstellenzustände codierten, vorzugsweise digitalen Signals anweist. Alle folgenden Ausführungen beziehen sich somit auf diesen Sendebetrieb, bei dem die Schnittstelle mittels der Zustandsänderungen Signale über angeschlossene Busleitungen aussendet.

Die Zustände sind dabei vorzugsweise diskret getrennte Spannungspegel. Der Spannungsverlauf im Übergang zwischen den wenigstens zwei Zuständen, also die ansteigenden oder abfallenden Flanken, stellen vorzugsweise selbst keine Information dar.

Auch wenn in folgenden der Sendebetrieb bzw. der Sendezweig einer Schnittstelle näher erläutert werden wird, kann die Schnittstelle natürlich wahlweise auch bidirektional ausgestaltet sein, indem sie optional zusätzlich einen Empfangszweig aufweist, der von den Busleitungen her Signale aufnimmt.

Ferner weist die Schnittstellenschaltung 100 eine Ansteuersignalformungsschaltung 70 auf, die ausgelegt ist, um in Abhängigkeit von einem Steuersignal das Ansteuersignal für die steuerbare Schaltanordnung 30 bereitzustellen, wobei die Ansteuersignalformungsschaltung 70 eine Flanken-Verlangsamungsschaltung 80 aufweist, die ausgelegt ist, um Flanken einer ersten Flankenrichtung des Ansteuersignals zu verlangsamen und Flanken einer zweiten Flankenrichtung des Ansteuersignals im Wesentlichen unbeeinflusst zu lassen.

Bei der steuerbaren Schaltanordnung 30 kann es sich beispielsweise um einen einzelnen Transistor handeln oder, wie später erläutert wird, auch um komplexere Schaltungen wie z. B. eine Darlingtonschaltung, handeln. Diese steuerbare Schaltanordnung 30 kann dann durch ein Ansteuersignal so angesteuert werden, dass z.B. an einem Eingang 22 der Schnittstellenschaltung 100 ein erster oder ein zweiter Schnittstellenzustand bewirkt werden kann. Bei diesem ersten oder zweiten Schnittstellenzustand kann es sich beispielsweise um einen Low-Pegel oder einem High-Pegel handeln, der dementsprechend einer logischen 0 oder einer logischen 1 entsprechen kann.

Die Ansteuersignalformungsschaltung 70 kann nun u. a. eine Flanken-Verlangsamungsschaltung 80 aufweisen, die ausgelegt ist, um eine Potentialerhöhung und damit einen Spannungsanstieg des Ansteuersignals für die steuerbare Schaltanordnung 30 zu verlangsamen. Das heißt, der Anstieg des Spannungspegels des Ansteuersignals kann durch die Flanken-Verlangsamungsschaltung verlangsamt werden, wohingegen beispielsweise ein Abfallen des Spannungspegels des Ansteuersignals durch die Flanken-Verlangsamungsschaltung 80 im Wesentlichen nicht beeinflusst wird. Damit kann also durch die Ansteuersignalformungsschaltung 70, die die Flanken-Verlangsamungsschaltung 80 aufweist, ein Ansteuersignal zur Erzeugung eines ersten Schnittstellenzustandes oder eines zweiten Schnittstellenzustandes so beeinflusst werden,
das die Flanken einer ersten Flankenrichtung des Ansteuersignals verlangsamt werden und Flanken einer zweiten Flankenrichtung des Ansteuersignals im Wesentlichen unbeeinflusst bleiben.

Handelt es sich beispielsweise bei dem ersten Schnittstellenzustand um einen High-Pegel, der an dem Schnittstellenschaltungseingang 22 anliegt, und wird durch einen Anstieg des Ansteuersignalpegels an der steuerbaren Schaltanordnung ein Low-Pegel bewirkt, der dem zweiten Schnittstellenzustand entsprechen kann, so kann die fallende Flanke vom High-Pegel auf den Low-Pegel durch die Verlangsamung des Anstiegs des Ansteuersignalspannungspegel durch die Flanken-Verlangsamungsschaltung ebenfalls verlangsamt werden. Eine steigende Flanke von einem Low-Pegel zu einem High-Pegel an dem Schnittstellenschaltungseingang 22 kann jedoch im Wesentlichen durch die Flanken-Verlangsamungsschaltung unbeeinflusst bleiben, wenn die steigende Flanke durch ein Abfallen des Spannungspegels des Ansteuersignals bewirkt wird, da die Flanken-Verlangsamungsschaltung den Abfall des Ansteuersignals im Wesentlichen unbeeinflusst lässt.

Wird die Schnittstellenschaltung 100 beispielsweise in einem DALI-System eingesetzt, so kann, wenn die steuerbare Schaltanordnung sperrt bzw. ausgeschaltet ist, d. h. nicht durchgesteuert ist, ein erster Schnittstellenzustand an einem Eingang der Schnittstellenschaltung einer hohen Spannung bzw. einem High-Pegel an der DALI-Schnittstelle entsprechen. Wird nun die steuerbare Schaltanordnung eingeschaltet oder durchgesteuert so kann ein "Kurzschluss" bzw. ein Low-Pegel an der DALI-Schnittstelle entstehen, wobei dies dem zweiten Schnittstellenzustand entsprechen kann. Das Steuersignal für die Ansteuersignalformungsschaltung 70 kann beispielsweise von einer Steuereinheit oder einem Mikroprozessor µC erzeugt werden, der Daten und/oder Steuerbefehle über die Schnittstellenschaltung 100 an einen Schnittstelleneingang 22 übertragen will. Der Schnittstelleneingang bzw. die Terminals 22 können an ein entsprechendes DALI-Bussystem gekoppelt sein.

In Fig. 2 ist ein weiteres Ausführungsbeispiel der erfindungsgemäßen Schnittstellenschaltung 100 in Form eines Blockschaltbildes dargestellt. Neben der steuerbaren Schaltanordnung 30, der Ansteuersignalformungsschaltung 70 und den Flanken-Verlangsamungsschaltung 80, die bereits in Zusammenhang mit der Fig. 1 erläutert wurden und deshalb an dieser Stelle nicht noch einmal beschrieben werden, weist das Ausführungsbeispiel in Fig. 2 einen Koppelschalter 72 auf, der ausgebildet ist, die Flanken-Verlangsamungsschaltung 80 in Abhängigkeit von dem Steuersignal an die steuerbare Schaltanordnung 30 zu koppeln oder im Wesentlichen zu entkoppeln. Das heißt durch den Koppelschalter 72 kann in Abhängigkeit des Steuersignals die Flanken-Verlangsamungsschaltung 80 zugeschaltet werden, um eine Flanke einer ersten Flankenrichtung des Ansteuersignals zu verlangsamen oder abgeschaltet werden, um Flanken einer zweiten Flankenrichtung des Ansteuersignals im Wesentlichen unbeeinflusst zu lassen.

Beispielsweise kann eine Steuereinheit eines elektronischen Vorschaltgerätes für Leuchtmittel in einem DALI-System ein Steuersignal bewirken, so dass die Flanken-Verlangsamungsschaltung 80 das Ansteuersignal verlangsamt, und damit die steuerbare Schaltanordnung 30, welche z. B. als Darlingtonschaltung ausgebildet sein kann, verlangsamt durchsteuert. Als Folge kann dann am Schnittstellenschaltungseingang 22, der mit dem DALI-Bussystem gekoppelt ist, zwischen Leitungen des DALI-Bussystems zumindest näherungsweise ein "Kurzschluss" hervorgerufen werden, wobei die fallende Flanke des sich aufgrund des "Kurzschlusses" ergebenden Bussignals bzw. aufgrund des Wirksamwerdens des "Kurzschlusses" verzögert bzw. verlangsamt wird.

Wird nun hingegen aufgrund des Steuersignals die Flanken-Verlangsamungsschaltung 80 durch Öffnen des Koppelschalters von der steuerbaren Schaltanordnung 30 entkoppelt, so wird das Ansteuersignal der steuerbaren Schaltanordnung bzw. eine Flanke desselben im Wesentlichen nicht durch die Flanken-Verlangsamungsschaltung 80 verlangsamt. Das heißt, in dem vorliegenden Ausführungsbeispiel, dass das Ansteuersignal bzw. ein Pegel desselben relativ schnell abfällt, und somit das Durchsteuern der steuerbaren Schaltanordnung 30 relativ schnell unterbrochen wird. Dadurch kann in einem DALI-System an einem Schnittstellenschaltungseingang 22 eine im Wesentlichen von der Flanken-Verlangsamungsschaltung 80 unbeeinflusste steigende Flanke zu einem High-Pegel hervorgerufen werden.

Bei dem Koppelschalter 72 kann es sich beispielsweise um eine Diode, einen Transistor oder eine andere Schaltanordnung handeln, die ausgebildet ist, in Abhängigkeit von einer anliegenden Spannung - dem Steuersignal - die Flanken-Verlangsamungsschaltung 80 an die steuerbare Schaltanordnung 30 zu koppeln oder im Wesentlichen von der steuerbaren Schaltanordnung 30 zu entkoppeln. Der Koppelschalter kann bei Überschreiten einer Koppelschwellspannung, also beispielsweise wenn eine Spannung zwischen der Koppelschalteranschlüssen größer als die Koppelschwellspannung ist, die Flanken-Verlangsamungsschaltung 80 an die steuerbare Schaltanordnung 30 koppeln und bei Unterschreiten dieser Koppelschwellspannung können diese im Wesentlichen entkoppelt werden. Im Falle einer Diode kann die Koppelschwellspannung der Diodendurchlassspannung und im Falle eines Transistors einer Basis-Emitter Durchlassspannung bzw. einer Transistoreinsatzspannung entsprechen.

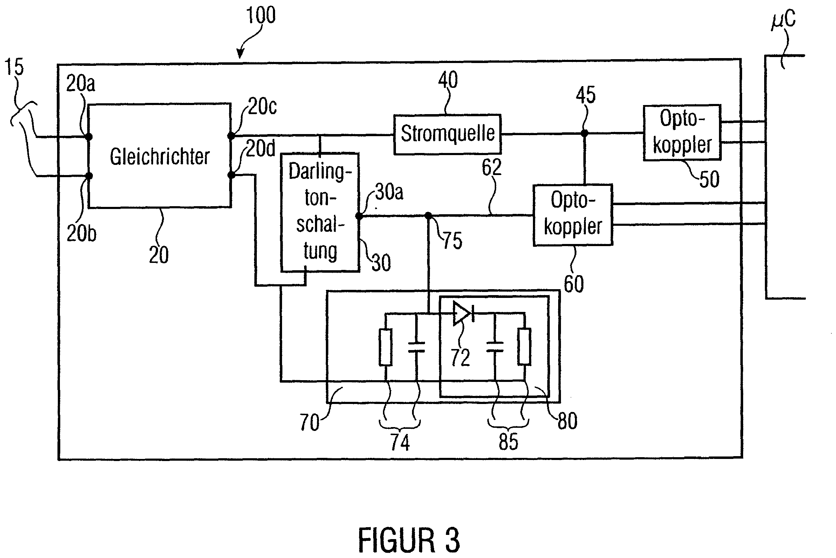

In dem schematischen Blockschaltbild in Fig. 3 ist ein weiteres Ausführungsbeispiel eine Schnittstellenschaltung 100 mit weiteren Schaltanordnungen dargestellt. Gemäß diesem Ausführungsbeispiel weist eine Schnittstellenschaltung 100 ferner eine Gleichrichterschaltung 20 auf, die ausgebildet ist, um in Abhängigkeit einer an Gleichrichtereingangsanschlüssen 20a, 20b anliegenden Gleichrichtereingangsspannung, an Gleichrichterausgangsanschlüssen 20c, 20d eine gleichgerichtete Gleichrichterausgangsspannung bereitzustellen. Die Gleichrichtereingangsanschlüsse 20a, 20b können die Terminals der Schnittstellenschaltung 100 bilden und damit dem Schnittstellenschaltungseingang 22 in den Figuren 1 und 2 entsprechen. Die Gleichrichtereingangsanschlüsse der Schnittstellenschaltung 100 können an ein Bus- oder Leitungssystem 15 angeschlossen werden. Bei dem Bussystem kann es sich beispielsweise um das bereits oben erwähnte DALI-Bussystem handeln. Die steuerbare Schaltanordnung 30 ist in diesem Ausführungsbeispiel als Darlingtonschaltung ausgebildet, die zwischen den Gleichrichterausgangsanschlüssen 20c und 20d gekoppelt ist. Ferner weist die Schnittstellenschaltung 100 eine Stromquelle 40 auf, die zwischen einen ersten Gleichrichterausgangsanschluss 20c und einen Ansteueranschluss 30a der Darlingtonschaltung 30 gekoppelt ist. Die Schnittstellenschaltung 100 weist ferner einen ersten Optokoppler 50 auf, der ausgebildet ist, Daten und/oder Steuerbefehle, die an den Gleichrichtereingangsanschlüssen 20a, 20b anliegen, an eine Steuereinheit oder einen Mikroprozessor µC zu übermitteln. Ferner kann die Schnittstellenschaltung einen zweiten Optokoppler 60 aufweisen, der ausgebildet ist, umgekehrt Daten und/oder Steuerbefehle von der Steuereinheit bzw. dem Mikroprozessor µC zu empfangen und diese an das Bussystem 15 weiterzugeben. Diese Daten und/oder Steuerbefehle können die Steuersignale darstellen, in deren Abhängigkeit die Ansteuersignalformungsschaltung 70 Ansteuersignale für die steuerbare Schaltanordnung 30 bereitstellt. In anderen Worten können also über den Optokoppler 60 Daten- oder Steuerbefehle digital über die Schnittstellenschaltung 100 an das Bussystem 15 übertragen werden. Eine weitere Verbesserung im Bereich der Flankensteilheit ergibt sich auch durch einen geringeren Strom im Optokoppler 60. Die Flanken-Verlangsamungsschaltung 80 weist in diesem Ausführungsbeispiel ein erstes RC-Glied 85 auf, welches über den Koppelschalter 72, der in diesem Ausführungsbeispiel als Diode ausgebildet ist, über den Ansteuersignalknoten 75 an die steuerbare Schaltanordnung 30 koppelbar ist.

In diesem Ausführungsbeispiel kann die Ansteuersignalformungsschaltung 70 neben der Flanken-Verlangsamungsschaltung 80 ferner ein zweites RC-Glied 74 aufweisen, das so mit dem Ansteuersignalknoten 75 gekoppelt ist, dass das erste RC-Glied 85 und das zweite RC-Glied bei einer Flanke der ersten Flankenrichtung des Ansteuersignals wirksam sind, um eine Veränderung eines Potenzials des Ansteuersignals zu verlangsamen, und dass bei einer Flanke der zweiten Flankenrichtung des Ansteuersignals eine Flankensteilheit des Ansteuersignals im Wesentlichen von dem zweiten RC-Glied 74 beeinflusst wird und von dem ersten RC-Glied 85 im Wesentlichen unbeeinflusst bleibt. Das zweite RC-Glied 74 ist über den Ansteuersignalknoten 75 an einen Ansteueranschluss 30a der Darlingtonschaltung gekoppelt. Bei diesem Ansteueranschluss 30a kann es sich beispielsweise um einen Basis- oder Steueranschluss eines eingangsseitigen Transistors der Darlingtonschaltung handeln.

Die Diode 72 weist eine Koppelschwellspannung auf, so dass das erste RC-Glied 85 an die steuerbare Schaltanordnung 30 koppelbar ist, sobald die Spannungsdifferenz zwischen der Spannung an dem Ansteuersignalknoten 75 und der Spannung an dem Diodenseitigen-Anschluss des RC-Gliedes die Diodendurchlassspannung überschreitet. Sinkt jedoch diese Spannungsdifferenz unter die Diodendurchlassspannung der Diode, so sperrt die Diode und das erste RC-Glied 85 wird von der steuerbaren Schaltanordnung 30 entkoppelt.

Das heißt, die Diode 72 koppelt bei einer an der Diode anliegenden Durchlassspannung die Flanken-Verlangsamungsschaltung 80 an die steuerbare Schaltanordnung 30. Falls eine geringere Spannung als die Diodendurchlassspannung an der Diode anliegt, so wird das erste RC-Glied 85 im Wesentlichen von der steuerbaren Schaltanordnung 30 entkoppelt und es ist überwiegend das zweite RC-Glied 74 wirksam im Bezug auf den zeitlichen Verlauf des Ansteuersignals.
Die RC-Zeitkonstante (τ2 =R10 x C7) des zweiten RC-Gliedes 74 kann so ausgelegt sein, um eine vorbestimmte Flankensteilheit der zweiten Flankenrichtung an den Gleichrichtereingangsanschluss 20a, 20b zu erzielen und eine RC-Zeitkonstante (τ1 = R16 x C8) des ersten RC-Gliedes 85 kann ausgelegt sein, um zusammen mit der RC-Zeitkonstante τ2 des zweiten RC-Gliedes 74 eine vorbestimmte Flankensteilheit der ersten Flankenrichtung eines Signals an den Gleichrichtereingangsanschlüssen 20a, 20b zu ermöglichen.

Die steuerbare Schaltanordnung 30, also z. B. eine Darlingtonschaltung, kann eine bestimmte Durchsteuerschwellspannung aufweisen, bei deren Überschreiten die steuerbare Schaltanordnung durchsteuert und die Gleichrichterausgangsanschlüsse 20c und 20d zumindest näherungsweise "kurzgeschlossen" werden. Diese Durchsteuerschwellspannung kann in Ausführungsbeispielen der vorliegenden Erfindung größer sein als eine Koppelschwellspannung des Koppelschalters 72 zum Koppeln der Flanken-Verlangsamungsschaltung 80 an die steuerbare Schaltanordnung 30. Beispielsweise kann also die Spannung, die benötigt wird, um die Darlingtonschaltung über Transistoren durchzusteuern, größer sein als die Diodendurchlassspannung der Diode 72 zum Ankoppeln des ersten RC-Gliedes 85 an die Darlingtonschaltung. In anderen Worten ist also eine Koppelschwellspannung zum Koppeln des ersten RC-Gliedes 85 geringer als eine Spannung, die nötig ist, um die steuerbare Schaltanordnung, also z. B. die Darlingtonschaltung, durchzusteuern, so dass beispielsweise die Gleichrichterausgangsanschlüsse 20c und 20d und damit auch die Gleichrichtereingangsanschlüsse 20a und 20b "kurzgeschlossen" werden.

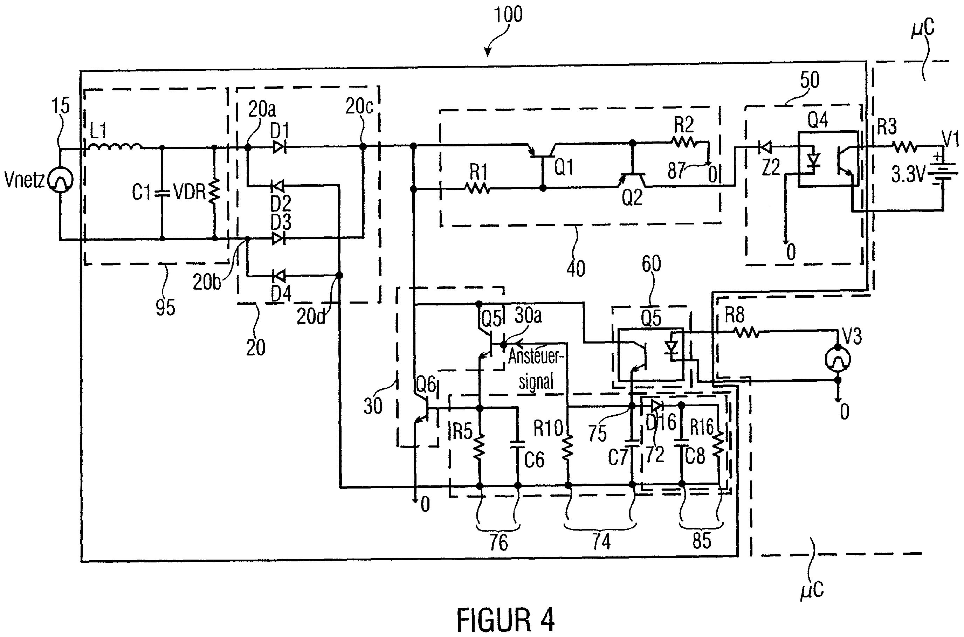

In Fig. 4 ist der Schaltplan einer Schnittstelle 100 gemäß einem weiteren Ausführungsbeispiel dargestellt. Die Schnittstellenschaltung 100 weist in diesem Ausführungsbeispiel eine Gleichrichterschaltung 20, eine Stromquelle 40, eine Schaltanordnung 50, eine Darlingtonschaltung 30, einen Optokoppler 60 sowie eine Ansteuersignalformungsschaltung 70 mit einer Flanken-Verlangsamungsschaltung 80 auf. Anhand des Schaltplans werden die einzelnen funktionalen Blöcke der verschiedenen Schaltanordnungen genauer beschrieben.

Wie in Fig. 4 weiter dargestellt ist, kann den Gleichrichtereingangsanschlüssen 20a, 20b ein Filter 95 vorgeschaltet sein, dessen Zweck es ist, Spannungspulse, die über das Bussystem oder die Leitungen 15 an die Terminals 20a, 20b der Schnittstellenschaltung 100 gelangen könnten, zu filtern bzw. zu dämpfen. Beispielsweise können in einem DALI-Bussystem 15 bzw. an die Leitungen 15 Taster, Sensoren oder andere Bedienelemente angeschlossen sein, um einen Betriebszustand wie z. B. die Helligkeit eines Leuchtmittels einzustellen. Durch das Betätigen dieser Bedienelemente, wie z.B. des Tasters, oder durch andere Schaltvorgänge auf dem Bussystem können störende Spannungspulse an die Gleichrichtereingangsanschlüsse 20a, 20b gelangen. Wird nämlich z. B. ein Taster betätigt, kann es durch das sogenannte Tastenprellen zur Erzeugung relativ energiearmer Störspannungspulse, die Amplituden bis in den Kilovolt-Bereich aufweisen können, kommen. Solche Tastersignale können z. B. über eine Netzspannung übertragen werden, d.h. es wird ein Taster an die Netzspannung gekoppelt. Sobald der Taster betätigt wird, wird kurzzeitig die Netzspannung an den Schnittstellenschaltungseingang durchgeschaltet und die Dauer des Anliegens der Netzspannung ausgewertet. Die Spannungsfestigkeit einer elektrischen Schaltung gegenüber solchen Spannungspulsen wird auch Signalpulsfestigkeit bzw. "Burstfestigkeit" genannt. Bei den Signalpulsen bzw. Burstpulsen handelt es sich um schnelle transiente Störgrößen, die in der Stromversorgung oder in den Signaleingängen der Schnittstellenschaltung eingekoppelt werden.

Befinden sich größere (Last-) Induktivitäten, wie z. B. Transformatoren, Drosseln usw. in den Leitungen oder dem Bussystem 15, können energiereiche Überspannungspulse bzw. sogenannte Surgepulse, die ebenfalls eine Amplitude bis in den Kilovolt-Bereich aufweisen, entstehen. Bei diesen Surgepulsen handelt es sich im Gegensatz zu den Burstpulsen um energiereiche transiente Spannungspulse, die sich als transiente Überspannungen bzw. Stoßspannungen, die bei Schaltvorgängen in bzw. auf den entsprechenden Leitungen entstehen können, bemerkbar machen können. Das Filter 95 kann beispielsweise so dimensioniert sein, dass Burstpulse bis zu einer Spannungserhöhung von einigen 10 V eliminiert werden können. Bei Surgepulsen kann zwar typischerweise die Spannungsamplitude durch ein Filter 95 auch stark reduziert werden, aber dennoch kann es vorkommen, dass bei einem 2 kV Spannungspuls noch eine Spannungsamplitude von beispielsweise 1 kV an die Schnittstellenschaltung, z.B. an die Gleichrichtereingangsanschlüsse 20a , 20b gelangt. Im vorliegenden Ausführungsbeispiel weist das Filter 95 eine Induktivität L1 mit einem Induktivitätswert von einigen µH, einen Kondensator C1 mit einer Kapazität von weniger als 1nF und einem 300 V Varistor VDR auf. Der Kondensator C1 und der Varistor VDR sind dabei als RC-Glied zwischen die Gleichrichtereingangsanschlüsse 20a und 20b geschaltet, während die Induktivität L1 in Serie zu dem RC-Glied und dem Gleichrichtereingangsanschluss 20a gekoppelt ist.

Bei der Gleichrichterschaltung 20 kann es sich beispielsweise um vier Dioden D1-D4 handeln, die in einer sogenannten Grätzanordnung verschaltet sind. Liegt an bzw. zwischen den Gleichrichtereingangsanschlüssen 20a, 20b eine Gleichrichtereingangsspannung an, die einem Signal oder Spannungspegel auf dem Bussystem 15 entspricht, so wird an den Gleichrichterausgangsanschlüssen 20c und 20d die entsprechende gleichgerichtete Gleichrichterausgangsspannung zur Verfügung gestellt. Zwischen den Gleichrichterausgangsanschlüssen 20c und 20d kann nun die steuerbare Schaltanordnung 30 gekoppelt sein. In diesem Ausführungsbeispiel umfasst die steuerbare Schaltanordnung 30 eine Darlingtonschaltung mit zumindest zwei Transistoren Q5 und Q6. In anderen Ausführungsbeispielen kann die steuerbare Schaltanordnung 30 jedoch beispielsweise auch nur aus einem Einzeltransistor oder anderen Schaltanordnungen bestehen, die geeignet sind, bei einem entsprechenden Ansteuersignal durchzusteuern, d. h. die Gleichrichterausgangsanschlüsse 20c, 20d näherungsweise "kurz zu schließen" oder niederohmig zu verbinden bzw. einen vergleichsweise großen Stromfluss zwischen den Gleichrichterausgangsanschlüssen 20c und 20d zu ermöglichen.

Die Darlingtonschaltung 30 weist einen in Abhängigkeit von einem Ansteuersignal steuerbaren ausgangsseitigen Strompfad 35 auf, der beispielsweise durch eine Kollektor-Emitter-Strecke des ausgangseitigen Bipolartransistors Q6 der Darlingtonschaltung gebildet 30 wird. Der Kollektoranschluss des Transistors Q6 ist beispielsweise mit dem Gleichrichterausgangsanschluss 20c und mit dem Kollektoranschluss des eingangsseitigen Transistor Q5 verbunden. Der entsprechende Emitteranschluss des Transistors Q6 ist mit dem Gleichrichterausgangsanschluss 20d und einem Bezugspotentialleiter, der beispielsweise auf einem Massepotential 87 liegen kann, gekoppelt. Der Basisanschluss des Transistors Q6 ist mit einem Emitteranschluss des Transistors Q6 gekoppelt und mit einem RC-Glied 76. Dieser ausgangsseitige steuerbare Strompfad 35 kann ausgebildet sein, um zwischen den Gleichrichterausgangsanschlüssen 20c und 20d eine in Abhängigkeit von dem Ansteuersignal veränderbare elektrische Last zu bilden. Das heißt, in Abhängigkeit des Ansteuersignals kann der Darlingtontransistor Q6 mit dem ausgangsseitigen steuerbaren Strompfad 35 durchsteuern, so dass die Gleichrichterausgangsanschlüsse 20c und 20d näherungsweise "kurzgeschlossen" werden. Falls das Ansteuersignal eine Durchsteuerschwellspannung übersteigt, werden also die Gleichrichterausgangsanschlüsse 20c und 20d über die Darlingtonschaltung 30 niederohmig verbunden bzw. es wird ein großer Stromfluss zwischen den Gleichrichterausgangsanschlüssen ermöglicht. Durch diesen "Kurzschluss" wird dann an den Gleichrichtereingangsanschlüssen 20a und 20b ein erster Schnittstellenzustand durch eine große Last bzw. einen großen Stromfluss bewirkt. Falls die Darlingtonschaltung nicht durchsteuert, wird ein zweiter Schnittstellenzustand mit einer kleinen Last bzw. einen kleinen Stromfluss bewirkt.

In einem DALI-System, bei dem im Ruhezustand eine Spannung an dem DALI-Bus anliegt, erfolgt dann bei solch einem "Kurzschluss" ein Zusammenbruch der Spannung, was dann als Active Low Signal im DALI-System interpretiert wird. Dieser Zustand kann dann beispielsweise dem ersten Schnittstellenzustand entsprechen. Wenn umgekehrt die steuerbare Schaltanordnung 30 aufgrund des Ansteuersignals nicht durchsteuert, also die Durchsteuerschwellspannung nicht erreicht oder unterschritten wird, bleibt die Spannung an den Gleichrichtereingangsanschlüssen unverändert oder baut sich wieder auf, was dem zweiten Schnittstellenzustand entsprechen kann. Die Ansteuersignalformungsschaltung 70 ist ausgelegt, um in Abhängigkeit eines Steuersignals das Ansteuersignal für die Darlingtonschaltung 30 bereitzustellen. Das Steuersignal kann beispielsweise von einem Mikroprozessor oder einer Steuereinheit, mit der die Schnittstellenschaltung 100 über den Optokoppler 60 gekoppelt ist, bereitgestellt werden.

In dem vorliegenden Ausführungsbeispiel weist die Ansteuersignalformungsschaltung 70 eine Flanken-Verlangsamungsschaltung 80 auf, die ein erstes RC-Glied 85 mit einem Kondensator C8 mit einem Kapazitätswert einigen nF und einen Widerstand R16 mit einem Widerstandswert von einigen kΩ, sowie einen Koppelschalter 72, der als Diode D16 ausgebildet ist, aufweist. Das erste RC-Glied 85 ist über den Koppelschalter 72 mit einem Ansteueranschluss 30a der Darlingtonschaltung 30, der beispielweise von dem Basisanschluss des eingangsseitigen Bipolartransistor Q5 gebildet wird, und mit einem zweiten RC-Glied 74 gekoppelt. Über einen bezugspotentialseitigen Anschluss ist das erste RC-Glied 85 außerdem mit einem Bezugspotentialleiter verbunden, der im vorliegenden Fall auf einem Massepotential 87 liegen kann.

Die Ansteuersignalformungsschaltung 70 umfasst in diesem Ausführungsbeispiel ein zweites RC-Glied 74 mit einem Kondensator C7 mit einem Kapazitätswert von einigen nF und einem Widerstand R10 mit einem Widerstandswert von einigen kΩ. Das zweite RC-Glied 74 ist ebenfalls mit dem Ansteueranschluss 30a der Darlingtonschaltung 30 und über den Ansteuersignalknoten 75 mit der Flanken-Verlangsamungsschaltung 80 gekoppelt. Außerdem weist auch das zweite RC-Glied 74 einen bezugspotentialseitigen Anschluss auf, mit dem das RC-Glied mit einem Bezugspotentialleiter verbunden ist, der im vorliegenden Fall auf einem Massepotential 87 liegen kann. Die Flanken-Verlangsamungsschaltung 80 sowie das zweite RC-Glied 74 sind in diesem Ausführungsbeispiel also über den Ansteuersignalknoten 75 an den Ansteueranschluss 30a der steuerbaren Schaltanordnung 30 gekoppelt.

Der Ansteueranschluss 30a kann in diesem Ausführungsbeispiel dem Basisanschluss bzw. dem Steueranschluss des eingangsseitigen Transistors Q5 der Darlingtonschaltung 30 entsprechen. Die Ansteuersignalformungsschaltung 70 kann ferner ein optionales drittes RC-Glied 76 mit einem Kondensator C6, der einen Kapazitätswert von einigen nF aufweist, und einem Widerstand R6 mit einem Widerstandswert im kΩ-Bereich umfassen. Dieses dritte RC-Glied 76 kann an die Basis oder den Steueranschluss des ausgangsseitigen Transistors Q6 , sowie dem Emitteranschluss des Transistors Q5 der Darlingtonschaltung angeschlossen sein und so ausgebildet sein, um einem Durchsteuern des ausgangsseitigen steuerbaren Strompfad 35 bzw. der steuerbaren Schaltanordnung 30 entgegenzuwirken. Ferner ist das dritte RC-Glied 76 mit seinem bezugspotentialseitigen Anschluss wieder mit dem Bezugspotentialleiter und dem Gleichrichterausgangsanschluss 20d verbunden. Dabei können der Bezugspotentialleiter und der Gleichrichterausgangsanschluss 20d wieder auf einem Massepotential 87 liegen. Das dritte RC-Glied kann das Durchsteuern und das Ausschalten des ausgangsseitigen Transistor Q6 bremsen und damit auch gleichzeitig Schutz gegen Zerstörung der Darlingtonschaltung 30 bei unerwünschten Spannungspulsen, wie z.B. den Surge- oder Burstpulsen am Schnittstelleneingang geben.

Wie bereits in Zusammenhang mit der Fig. 3 erläutert wurde, kann auf ein Steuersignal über den Optokoppler 60 hin und in Abhängigkeit von einem Potenzial an dem Ansteuersignalknoten 75 das erste RC-Glied 85 an die steuerbare Schaltanordnung 30 gekoppelt werden oder von dieser im Wesentlichen entkoppelt werden, so dass eine Flanke einer ersten Flankenrichtung des Ansteuersignals verlangsamt wird und eine Flanke einer zweiten Flankenrichtung des Ansteuersignals im Wesentlichen unbeeinflusst bleibt, wenn das erste RC-Glied von der steuerbaren Schaltanordnung entkoppelt ist. Das Koppeln bzw. entkoppeln erfolgt bei der Flanken-Verlangsamungsschaltung 80 der Fig. 4 vollständig in Abhängigkeit von einer Potentialdifferenz zwischen den diodenseitigen Knoten, also der Kathode und der Anode der Diode.

Wird der Optokoppler 60 durchgeschaltet, wird das Potenzial an dem Ansteuersignalknoten 75 bzw. an der diodenseitigen Elektrode des Kondensator C7 auf ein höheres Potenzial gezogen, wenn eine Spannung, wie z. B. in einem DALI-Bussystem im Ruhezustand üblich, an den Gleichrichtereingangsanschlüssen 20a, 20b anliegt, da der Widerstand R10 als Pull-Down-Widerstand wirkt und die Kapazität C6 bei abgeschalteten Optokoppler 60 entlädt. Dieses Potenzial kann nun ansteigen bis der Koppelschalter 72 bzw. die Diode D16 durchschaltet, also die Diodendurchlassspannung erreicht ist, so dass dann ab dem Leitend-Werden der Diode D16 auch das erste RC-Glied 85 verlangsamend auf den Potenzialanstieg des Ansteuersignals für die Darlingtonschaltung einwirkt. Die An- und Abkopplung des RC-Netzwerkes 85 über die Diode 72 ist in diesem Ausführungsbeispiel möglich, weil zum Durchschalten der Transistoren Q5 und Q6 eine zweimal so hohe Spannung (eine zweifache Basis-Emitter Durchlassspannung) wie für das Durchschalten der Diode (Durchlassspannung der Diode D16) an dem Knoten 75 nötig ist. Das heißt, die Spannung am Ansteuersignalknoten 75 kann ansteigen, wobei die Zeitkonstante des Ansteuersignalanstiegs im Wesentlichen durch das Aufladen des Kondensators C7, also die RC- Zeitkonstante des zweiten RC-Gliedes 74 bestimmt ist, bis die Diodendurchlassspannung erreicht ist. Danach schaltet die Diode durch bzw. wird leitend und das erste RC-Glied 85 wird an die steuerbare Schaltanordnung 30 angekoppelt, so dass dann auch der Kondensator C8 aufgeladen wird und der Anstieg des Potenzials bzw. der Spannung des Ansteuersignalknotens 75 auch durch das erste RC-Glied 85 verlangsamt wird. Die Diode D16 wird nur dann leitend, wenn an ihrer Anode ein positives Potenzial gegenüber der Kathode anliegt, das größer als die Diodendurchlassspannung ist. Der Anstieg des Potenzials wird nun sowohl von dem ersten RC-Glied als auch von dem zweiten RC-Glied bestimmt. Sobald dann ungefähr die zweifache Durchlassspannung (U_{BE} = Basis-Emitter Spannung) der Transistoren erreicht wird, also die Durchsteuerschwellspannung überschritten wird, steuert die Darlingtonschaltung 30 durch.

Allgemein heißt das, dass die steuerbare Schaltanordnung 30 eine Durchflussschwellspannung zum Durchsteuern der steuerbaren Schaltanordnung aufweisen kann, die größer ist als eine Koppelschwellspannung des Koppelschalters 72 zum Koppeln der Flanken-Verlangsamungsschaltung 80 an die steuerbare Schaltanordnung. Wenn die Ansteuersignalspannung, die nötig ist, um die steuerbare Schaltanordnung durchzuschalten, größer ist als die Koppelschwellspannung, also in diesem Fall die Diodendurchlassspannung, kann eine Flanke einer ersten Flankenrichtung des Ansteuersignals verlangsamt werden. Beispielsweise kann es sich dabei um die steigende Flanke des Ansteuersignals für die steuerbare Schaltanordnung 30 handeln, welche in eine fallende Flanke des Bussignals resultiert.

Eine zweite Flankenrichtung des Ansteuersignals, also beispielsweise hier die fallende Flanke des Ansteuersignals, bleibt jedoch im Wesentlichen von dem ersten RC-Glied 85 unbeeinflusst. Wird nämlich der Optokoppler 60 gesperrt, so kann sich der erste RC-Filter bzw. das erste RC-Glied 85 während dieser "High-Phase" bezogen auf das Bussignal weitgehend über den Widerstand R16, welcher mit einem Massepotential 87 gekoppelt ist, entladen. Dazu sollte die RC-Zeitkonstante (τ1 = R16 x C8) des ersten RC-Gliedes 85 passend gewählt werden. Aufgrund der Parallelschaltung der Widerstände R10 und R16 wird in geringem Maße jedoch auch die zweite Flankenrichtung, die abfallende Flanke des Ansteuersignals, beeinflusst.

An dieser Stelle sollte noch einmal darauf hingewiesen werden, dass in einem DALI-System eine steigende Flanke des Ansteuersignals zu einem Durchsteuern der steuerbaren Schaltanordnung führt und dies dann am Schnittstelleneingang, also bei den Gleichrichtereingangsanschlüssen 20a und 20b, zu einer fallenden Flanke auf dem Bussystem führt. Umgekehrt kann eine fallende Flanke des Ansteuersignals zu einem Sperren der steuerbaren Schaltanordnung 30 führen und damit zu einer steigenden Flanke an dem Schnittstellenschaltungseingang bzw. an den Gleichrichtereingangsanschlüssen 20a, 20b, also auf dem Bussystem In dem vorliegenden Ausführungsbeispiel sind also für eine fallende Flanke eines Bussignals am Bussystem 15 im Wesentlichen das zweite RC-Glied 74 und das erste RC-Glied 85 wirksam, während für eine steigende Flanke eines Bussignals am Bussystem 15 im Wesentlichen nur das zweite RC-Glied 74, nicht aber das erste RC-Glied 85 wirksam ist. Das bedeutet aber auch, dass die Flankensteilheit einer ersten Flankenrichtung und einer zweiten Flankenrichtung nicht völlig unabhängig voneinander eingestellt werden können. Wird z. B. eine RC-Zeitkonstante des zweiten RC-Gliedes 75 geändert, um eine bestimmte Flankensteilheit einer steigenden Flanke des Bussignals zu erhalten, kann damit auch eine Flankensteilheit einer fallenden Flanke geändert werden.

Die Anstiegszeit bzw. die steigende Flanke eines Bussignals am Schnittstellenschaltungseingang 20a, 20b kann nun durch Festlegung der RC-Zeitkonstante des zweiten RC-Gliedes 75, also des Widerstands R10 und des Kondensators C7, festgelegt werden. Anschließend kann dann eine Abfallzeit bzw. eine fallende Flanke eines Bussignals am Schnittstellenschaltungseingang durch entsprechende Dimensionierung der RC-Zeitkonstante des ersten RC-Gliedes bestehend aus dem Widerstand R16 und dem Kondensator C8 festgelegt werden, wobei darauf zu achten ist, dass der Kondensator C8 einen Kapazitätswert aufweist, der dann während einer entsprechenden Phase des Entkoppelns von der steuerbaren Schaltanordnung wieder entladen wird bis eine nächste fallende Flanke am Schnittstellenschaltungseingang eingeleitet wird. Ferner sollte darauf geachtet werden, dass die gesamte Schnittstellenschaltung so niederohmig wie möglich auszulegen ist, um jede Art von Einkoppelung maximal zu dämpfen.

In einem Ausführungsbeispiel kann eine RC-Zeitkonstante des zweiten RC-Gliedes 74 so ausgelegt sein, um eine vorbestimmte Flankensteilheit einer zweiten Flankenrichtung zu erzielen, und eine RC-Zeitkonstante des ersten RC-Gliedes 85 kann so ausgelegt sein, um zusammen mit der RC-Zeitkonstante des zweiten RC-Gliedes eine vorbestimmte Flankensteilheit der ersten Flankenrichtung des Ansteuersignals zu erzielen.

In Fig. 4 weist die Ansteuersignalformungsschaltung 70 ferner ein drittes RC-Glied 76 auf, wobei das dritte RC-Glied mit dem Steueranschluss des ausgangsseitigen Transistors Q6 der Darlingtonschaltung gekoppelt ist. Das dritte RC-Glied weist in diesem Ausführungsbeispiel einen Kondensator C6 mit einer Kapazität von einigen nF und einem Widerstand R6 mit einem Widerstandswert im kQ-Bereich auf. Dieses dritte RC-Glied kann nun ebenfalls dazu dienen, um ein Durchsteuern der steuerbaren Schaltanordnung 30, in diesem Ausführungsbeispiel also der Darlingtonschaltung, entgegen zu wirken. Das heißt, eine entsprechende fallende Flanke eines Bussignals am Schnittstellenschaltungseingang 20a, 20b bzw. 22 kann verlangsamt bzw. zeitlich verlängert werden.

Die Schnittstellenschaltung 100 kann ferner, wie in Fig. 4 dargestellt ist, eine Stromquelle 40 aufweisen, die zwischen den ersten Gleichrichterausgangsanschluss 20c und die Schaltanordnung 50 gekoppelt ist. Die Stromquelle 40 weist in diesen Ausführungsbeispielen die beiden pnp-Bipolartransistoren Q1 und Q2 sowie die Widerstände R1 mit einem Widerstandswert von einigen Hundert Ohm und einen Widerstand R2 mit einem Widerstandswert von mehr als Hundert kΩ auf. Der Bipolartransistor Q1 kann als Regelungstransistor für den Bipolartransistor Q2 wirken, da er über seinen steuerbaren Strompfad mit dem Basisanschluss des Transistors Q2 gekoppelt ist. Der Emitteranschluss des Transistors Q1 und der Widerstand R1 sind an den Gleichrichterausgangsanschluss 20c angeschlossen und ein Basisanschluss des Transistors Q1 ist zwischen dem weiteren Anschluss des Widerstandes R1 und dem Emitteranschluss des Transistors Q2 geschaltet. Ferner ist der Kollektoranschluss des Transistors Q1 zum einen an den Basisanschluss des Transistors Q2 und zum anderen über den Widerstand R2 mit einem Bezugspotential, wie z.B. dem Massepotential 90, gekoppelt. Der Widerstand R2 ist zwischen einem Bezugspotential, wie z.B. dem Massepotential 90, und dem Basisanschluss des Transistors Q2 geschaltet. Der Kollektoranschluss des Transistors Q2 ist über den Knoten 70 mit der Schaltanordnung zur Spannungsbegrenzung 50 und mit dem Optokoppler 60 verbunden.

Da der zweite Widerstand R2 dabei an das Massepotential 90 angeschlossen ist, kann ein Basisstrom des Transistors Q2 bei kleinen Eingangsspannungen, die einem Low-Pegel des DALI-Systems an dem Schnittstellenschaltungseingang entsprechen können, wegen der um die Zenerdiode Z2 und der Optokopplerspannung der Schaltungsanordnung 50 erhöhten Spannung an dem Widerstand R2, entscheidend erhöht werden.

Die Schaltungsanordnung 50 weist in diesem Ausführungsbeispiel einen Optokoppler Q4 und eine in Sperrrichtung betriebene Zenerdiode Z2 auf. Der Optokoppler Q4 dient dazu, Daten und/oder Steuersignale, die an den Gleichrichtereingangsanschlüssen 20a, 20b anliegen, an eine entsprechende Steuereinheit µC, welche beispielsweise in einem Vorschaltgerät für Leuchtmittel integriert sein kann, zu übertragen.

Umgekehrt dient der Optokoppler 60 dazu, von der Steuereinheit bzw. dem Mikroprozessor µC Daten- und/oder Steuersignale zu empfangen und entsprechende Steuersignale für die Ansteuersignalformungsschaltung 70 bereitzustellen, so dass darauf basierend Daten und/oder Steuerbefehle an das Bussystem 15 übertragen werden.

Gemäß einem weiteren Ausführungsbeispiel der vorliegenden Erfindung weist eine Ansteuersignalformungsschaltung 70 einer Schnittstellenschaltung lediglich eine wie in Fig. 4 ausgebildete Flanken-Verlangsamungsschaltung 80 mit einem ersten RC-Glied 85 und dem Koppelschalter 72, der als Diode D16 ausgebildet sein kann, auf. Das heißt, dass das erste RC-Glied 85 bei Überschreiten der Diodendurchlassspannung bei einer ersten Flankenrichtung des Ansteuersignals wirksam sein kann und es damit verlangsamen kann und bei einer zweiten Flankenrichtung des Ansteuersignals das RC-Glied 85 entkoppelt wird wenn die Diode sperrt und damit im Wesentlichen die Flanke der zweiten Flankenrichtung unbeeinflusst bleibt von dem ersten RC-Glied.

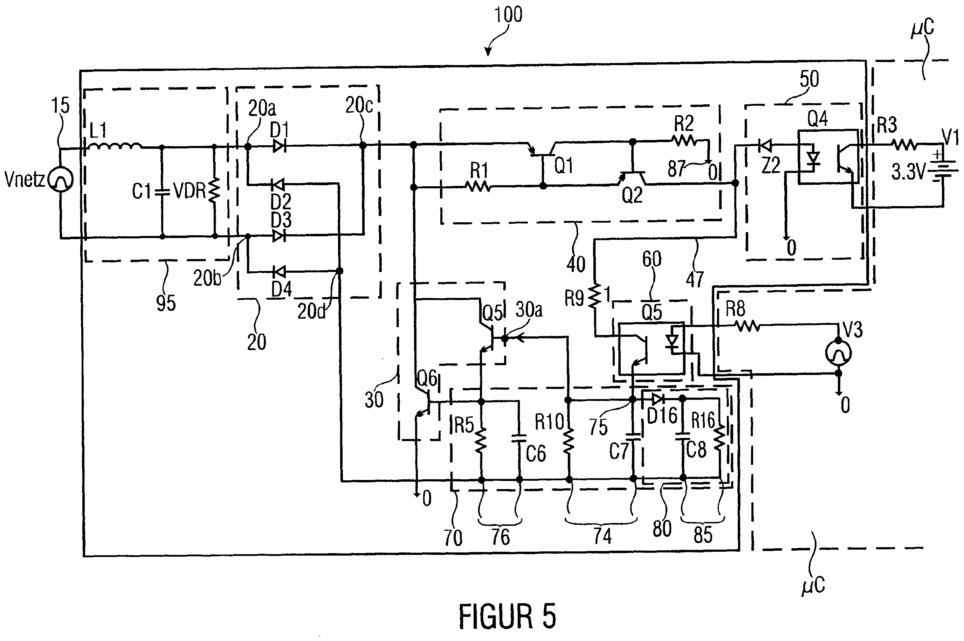

In Fig. 5 ist der Schaltplan einer Schnittstellenschaltung gemäß einem weiteren Ausführungsbeispiel der vorliegenden Erfindung dargestellt. Die Schnittstellenschaltung weist im Wesentlichen die Schaltungsteile, wie sie im Zusammenhang mit Fig. 4 beschrieben wurde, auf, weshalb hier auf eine weitere Beschreibung verzichtet wird. Die Schnittstellenschaltung kann also wiederum ein Filter 95, eine Gleichrichterschaltung 20, eine Stromquelle 40, eine Schaltungsanordnung 50, eine steuerbare Schaltanordnung 30 sowie eine Ansteuersignalformungsschaltung 70 mit einer Flankenverlangsamungsschaltung 80 und einem Optokoppler zum Empfang von Daten- und/oder Steuersignalen von einem Mikroprozessor aufweisen.

Bei der Schnittstellenschaltung 100 in Fig. 5 kann es sich jedoch um einen spannungsfeste Schnittstellenschaltung handeln, d. h. die Schnittstellenschaltung 100 kann eine hohe Spannungsfestigkeit gegenüber Spannungspulsen, wie z. B. den oben erwähnten Surgepulsen oder Burstpulsen, aufweisen. Diese Spannungsfestigkeit kann einerseits dadurch erreicht werden, dass beispielsweise die Transistoren oder Bauelemente der steuerbaren Schaltanordnung 30 eine entsprechend hohe Spannungsfestigkeit aufweisen.

Wie in Fig. 5 dargestellt ist, kann die steuerbare Schaltanordnung als Darlingtonschaltung 30 ausgebildet sein. Diese Darlingtonschaltung kann mindestens zwei Transistoren, z. B. Bipolartransistoren oder aber auch Feldeffekt-Transistoren aufweisen, die eine hohe Spannungsfestigkeit aufweisen. Beispielsweise kann die Darlingtonschaltung Bipolartransistoren aufweisen, die eine Kollektor-Emitter-Spannungsfestigkeit von zumindest 100 V, zumindest 600 V oder zumindest 1000 V aufweisen können. Ferner können, wie schon in dem Ausführungsbeispiel in Fig. 4 beschrieben, ein oder mehrere Ansteueranschlüsse der zumindest zwei Transistoren Q5, Q6 der Darlingtonschaltung 30 mit einem Kondensator bzw. mit jeweilig zugeordneten Kondensatoren verbunden sein. Im vorliegenden Ausführungsbeispiel ist also beispielsweise der Basisanschluss bzw. der Steueranschluss des Transistors Q6 mit dem Kondensator C6 und der Basisanschluss bzw. Steueranschluss des Transistors Q5 mit dem Kondensator C7 gekoppelt. Die Kapazitäten der entsprechenden Kondensatoren können größer sein als eine so genannte Miller-Kapazität zwischen einem Kollektor und einer Basis der jeweiligen Transistoren. Liegt eine entsprechend dimensionierte Kapazität an einem Basis- oder Steueranschluss eines Transistors der Darlingtonschaltung an, so wirkt diese Kapazität einem Durchsteuern des ausgangsseitigen steuerbaren Strompfades 35 der Darlingtonschaltung entgegen und verbessert somit eine Unempfindlichkeit gegen hohe Spannungspulse am Schnittstellenschaltungseingang

Sollte also beispielsweise in Abwesenheit des Kondensators durch einen Hochspannungspuls, der beispielsweise über eine Kollektor-Emitter-Strecke eines Transistors der Darlingtonschaltung anliegt, ein Durchsteuern über die Miller-Kapazität bzw. zumindest ein Impuls zu dem Basisanschluss erfolgen, so kann dies durch einen entsprechend dimensionierten Kondensator, der an die Basis des jeweiligen Transistors angeschlossen ist, verhindert werden bzw. es kann der Spannungspuls des zu dem Basisanschluss gekoppelten Impulses verringert werden. Allgemein kann also der Kapazitätswert des Kondensators, der mit der Basis des Transistors gekoppelt wird, auf die Miller-Kapazität des angeschlossenen Transistors und der gewünschten betreffenden Spannungsfestigkeit abgestimmt sein.

Die Stromquelle 40 und die Schaltungsanordnung 50 bilden wieder den Empfangskanal für einen über den Optokoppler Q4 der Schaltungsanordnung 50 gekoppelten Mikroprozessor. Die Stromquelle 40 ist in diesem Ausführungsbeispiel über den Knoten 45 und dem Leiterstück 47 mit einem Ansteueranschluss 30a der steuerbaren Schaltanordnung 30 gekoppelt. Im vorliegenden Fall kann der Ansteueranschluss 30a die Basis des eingangsseitigen Transistors Q5 der Darlingtonschaltung 30 sein. Die Basis von Transistor Q5 ist dann durch die Kopplung über die Stromquelle und die Spannungsbegrenzungsanordnung 50 vor Überspannungspulsen über den Eingangskanal der Schnittstellenschaltung geschützt. Im vorliegenden Ausführungsbeispiel kann die Konstantstromquelle 40 so ausgebildet sein, dass der Strom über den Transistor Q2 bzw. den Optokoppler 60 größer als150 µA ist, damit der ausgangsseitige Transistor Q6 250 mA Strom ziehen kann, falls am Eingang der Schnittstellenschaltung eine Spannung von weniger als 4,5 V, wie bei einem Low-Pegel in einem DALI-Bussystem, anliegt. In diesem Ausführungsbeispiel kann die spannungsfeste Schnittstellenschaltung 100 Transistoren Q5, Q6 mit einer Kollektor-Emitter-Spannungsfestigkeit von mehr als 500 V bzw. 600 V aufweisen, wobei die Transistoren eine gemeinsame Stromverstärkung größer als 1500 oder größer als 2000 aufweisen können. Dabei sollte ein Kollektorstrom in einem Bereich zwischen 1 mA und 300 mA verfügbar sein. Der Transistor Q6 kann eine Stromverstärkung größer als 80 ebenfalls in einem Strombereich von 1 mA bis 300 mA aufweisen. Für den Treiber-Transistor Q5 kann der Strombereich für die Stromverstärkung in einem Bereich von 1 mA bis 4 mA liegen.

Gemäß Ausführungsbeispielen kann die Schnittstellenschaltung 100 ausgebildet sein, Steuer- und/oder Datensignale zwischen einem Bussystem 15 und einer Steuereinheit bzw. einem Mikroprozessor µC, zwischen denen die Schnittstellenschaltung 100 gekoppelt ist, auszutauschen. Das heißt, einerseits können von einem Bussystem 15, wie z. B. dem DALI- Bussystem, Daten und/oder Steuerbefehle zu einer Steuereinheit oder zu einen Mikroprozessor, welcher beispielsweise in einem elektrischen Vorschaltgerät für Leuchtmittel integriert sein kann, über die Schnittstellenschaltung gesendet werden und andererseits können auch Daten und/oder Steuerbefehle von einer Steuereinheit oder einem Mikroprozessor empfangen werden. Die Schnittstellenschaltung kann also ausgebildet sein, um einen bidirektionalen Datenaustausch zwischen einem Bussystem und einer Steuereinheit oder einem Mikroprozessor zu ermöglichen.

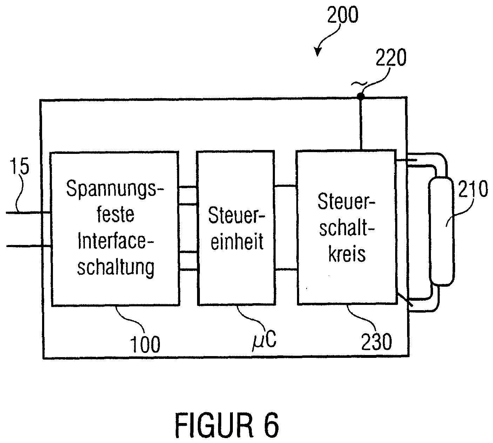

Dementsprechend umfasst die Erfindung wie in Fig. 6 schematisch dargestellt ist, auch ein elektrisches Vorschaltgerät für Leuchtmittel mit einer Schnittstellenschaltung 100. Gemäß einem Ausführungsbeispiel kann ein elektrisches Vorschaltgerät 200 für Leuchtmittel 210 eine im Zusammenhang mit den Fig. 1 bis 5 beschriebene Schnittstellenschaltung 100 aufweisen. Bei dem durch das Vorschaltgerät gesteuerte Leuchtmittel kann es sich beispielsweise um eine Glühlampe oder eine Gasentladungslampe handeln. Das Vorschaltgerät 200 kann ferner eine Steuereinheit bzw. einen Mikroprozessor oder Mikrocontroller aufweisen, der ausgebildet ist, den Betriebszustand des Leuchtmittels 210 über einen Steuerschaltkreis 230 zu steuern. Solch ein Betriebszustand kann beispielsweise ein bestimmter einzustellender Helligkeitswert des Leuchtmittels 210 sein. Das Vorschaltgerät kann über einen eigenen Spannungsversorgungsanschluss 220 verfügen. Das Leuchtmittel kann also beispielsweise bei 220V betrieben werden, während das oben erwähnte Bussystem 15 bei einer Spannung in einem Bereich von -22,5V bis+22,5V betrieben werden kann. Die Einstellung eines bestimmten Betriebszustandes kann durch einen Steuerbefehl veranlasst werden. Dieser Steuerbefehl kann von dem Bussystem 15 über die spannungsfeste Schnittstellenschaltung 100 an die Steuereinheit µC, die dann die entsprechende Ansteuerung des Steuerschaltkreises 230 übernimmt, übertragen werden. Beispielsweise kann also von einer zentralen Steuereinheit oder einem Taster bzw. einem Sensor, die an das Bussystem 15 angeschlossen sind, ein Steuerbefehl zum Einstellen eines bestimmten Helligkeitswertes über die spannungsfeste Schnittstellenschaltung an die Steuereinheit µC des Vorschaltgerätes 200 weitergegeben werden. Diese kann dann beispielweise veranlassen, dass durch eine Änderung einer Frequenz und/oder eines Tastverhältnisses eine von einem Wechselrichter gelieferte getaktete Wechselspannung für das Leuchtmittel 210 im Steuerschaltkreis 230 so verändert wird, dass der gewünschte Helligkeitswert eingestellt wird. Bei dem Leitungs- bzw. Bussystem 15 kann es sich um das DALI-Bussystem handeln, in dem Daten und/oder Steuerbefehle gemäß einem DALI-Protokoll übertragen werden. Die Steuereinheit bzw. der Mikrocontroller µC kann so ausgebildet sein, dass er anhand der Signalstruktur der Signale, die ihm über die spannungsfeste Schnittstellenschaltung 100 zugeführt werden, erkennen kann, ob es sich beispielsweise um Tastersignale, das heißt, einfache Impulssignale oder beispielsweise auch um Digital-Serial-Schnittstelle (DSI)-Signale, das heißt, Signale gemäß einem bestimmten digitalen Protokoll, handelt. Abhängig von der Art der Daten bzw. Steuerbefehle können diese dann unterschiedlich verarbeitet werden.

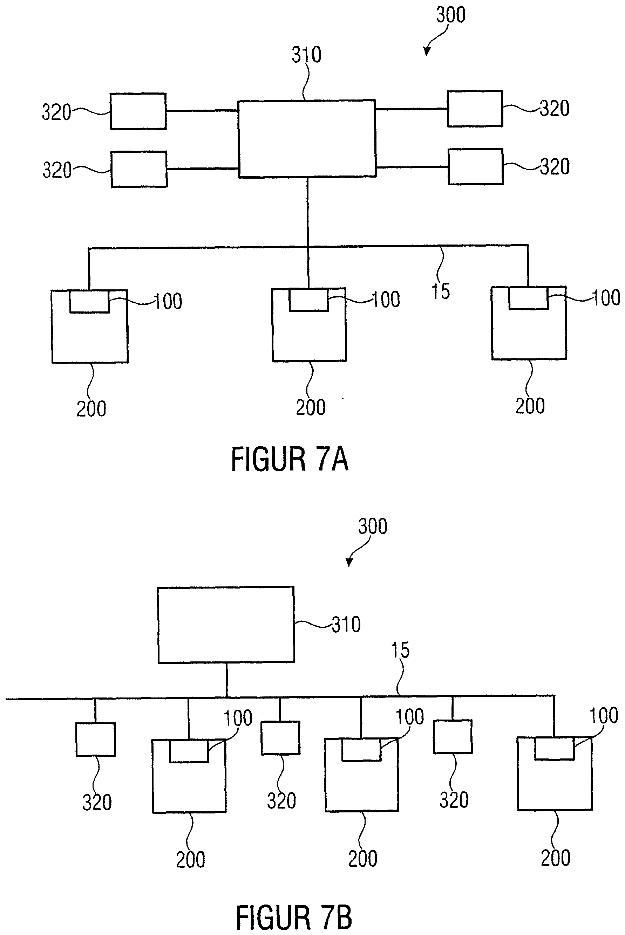

Wie in den Fig. 7a-b schematisch dargestellt ist, umfasst die Erfindung allgemein auch ein Beleuchtungssystem 300 zur Steuerung von Leuchtmitteln mit einer zentralen Steuereinheit 310, welche ausgebildet ist, einen Betriebszustand eines Leuchtmittels einzustellen oder abzufragen. Ferner weist das Beleuchtungssystem 300 zumindest ein elektrisches Vorschaltgerät 200 für Leuchtmittel auf, wobei das Vorschaltgerät eine Schnittstellenschaltung 100, wie sie im Zusammenhang mit den Fig. 1 bis 5 beschrieben wurde, aufweist. Die zentrale Steuereinheit 310 und das elektrische Vorschaltgerät 200 können über das Bussystem 15 zur Übertragung von Daten- und/oder Steuersignalen elektrisch miteinander gekoppelt sein. Das Bussystem kann, wie im Zusammenhang mit den Fig. 1 bis 5 beschrieben ist, an die Schnittstellenschaltung 100 elektrisch gekoppelt sein. Bei dem Bussystem 15 kann es sich beispielsweise um ein DALI-Bussystem handeln, auf dem Daten- und/oder Steuersignale gemäß einem DALI-Protokoll zwischen der zentralen Steuereinheit 310 und dem Vorschaltgerät übertragen werden können. Denkbar ist jedoch auch, dass es sich um ein anderes Bussystem handelt. Die Übertragung kann bidirektional erfolgen, weshalb die spannungsfeste Schnittstellenschaltung 100 ausgebildet sein kann, entsprechende Daten- und/oder Steuersignale bidirektional zwischen einem elektrischen Vorschaltgerät und der zentralen Steuereinheit 310 zu übertragen.

Gemäß weiterer Ausführungsbeispiele können auch andere Betriebselemente zur Steuerung eines Betriebszustandes eines Leuchtmittels an das Bussystem angeschlossen sein. Dabei kann es sich beispielsweise um Schalter, Kontrolltafeln, Taster, Sensoren usw. handeln. Wie in Fig. 7a dargestellt ist, können dabei Sensoren und Bedienelemente 320 über separate Verbindungen direkt an die zentrale Steuereinheit 310 angebunden sein oder aber die Sensoren und Bedienelemente 320 können über das DALI-Bussystem 15 an die zentrale Steuereinheit 310 und die Vorschaltgeräte 200 angeschlossen sein, wie in der Fig. 7b schematisch dargestellt ist.

Ferner sollte angemerkt werden, dass Aspekte der Erfindung, die in Zusammenhang mit einer Vorrichtung beschrieben wurden, auch eine Beschreibung eines entsprechenden Verfahrens darstellen, so dass ein Block oder ein Bauelement einer Vorrichtung auch als ein entsprechender Verfahrensschritt oder als ein Merkmal eines Verfahrensschrittes zu verstehen ist. Analog dazu stellen Aspekte, die in Zusammenhang mit einem oder als ein Verfahrensschritt beschrieben wurden, auch eine Beschreibung eines entsprechenden Blocks oder Details oder Merkmals einer entsprechenden Vorrichtung dar.

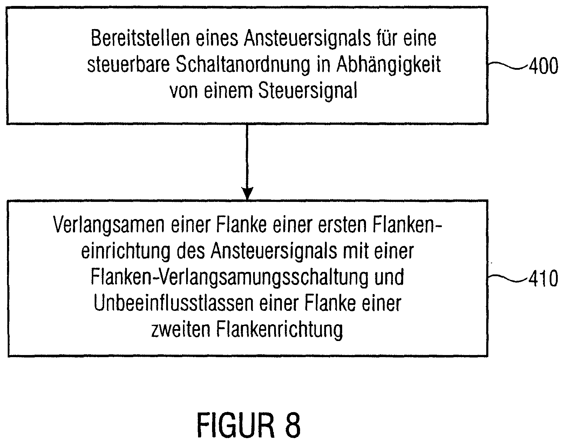

In Fig. 8 ist ein Flussdiagramm zu einem Ausführungsbeispiel eines Verfahrens zur Beeinflussung der Flankensteilheit eines Ansteuersignals für eine steuerbare Schaltanordnung dargestellt. Die steuerbare Schaltanordnung kann ausgelegt sein, um in Abhängigkeit von dem Ansteuersignal einen ersten Schnittstellenzustand oder einen zweiten Schnittstellenzustand an einer Schnittstellenschaltung zu bewirken. Das Verfahren kann in diesem Ausführungsbeispiel folgende Schritte umfassen: Bereitstellen 400 eines Ansteuersignals für die steuerbare Schaltanordnung in Abhängigkeit von einem Steuersignal einer Ansteuersignalformungsschaltung und Verlangsamen 410 einer Flanke einer ersten Flankenrichtung des Ansteuersignals mit einer Flanken-Verlangsamungsschaltung der Ansteuersignalformungsschaltung und im Wesentlichen Unbeeinflusstlassen einer Flanke, einer zweiten Flankenrichtung des Ansteuersignals.

Gemäß einem weiteren Ausführungsbeispiel kann der Schritt des Verlangsamens 410 einer Flanke einer ersten Flankenrichtung des Ansteuersignals ein Koppeln eines RC-Gliedes an die steuerbare Schaltanordnung aufweisen und das im Wesentlichen Unbeeinflusstlassen einer Flanke einer zweiten Flankenrichtung des Ansteuersignals durch ein Entkoppeln des RC-Gliedes von der steuerbaren Schaltanordnung.

Ferner sollte darauf hingewiesen werden, dass sich, obwohl in vorliegenden Ausführungsbeispielen oft auf eine Schnittstellenschaltung mit dem Einsatzgebiet in Beleuchtungssystemen eingegangen wurde, die erfindungsgemäße Schnittstellenschaltung und das entsprechende Verfahren gemäß weiterer Ausführungsbeispiele auch in anderen elektronischen oder mikroelektronischen Schaltungen oder Übertragungssystemen einsetzen lassen. Dazu kann eine entsprechende Anpassung der Bauteilspezifikationen und Kenngrößen an die jeweiligen Gegebenheiten nötig sein.

## Patentansprüche

1. Schnittstellenschaltung (100) mit einem Sendezweig, der aufweist:
- eine steuerbaren Schaltanordnung (30), die ausgebildet ist, um in Abhängigkeit von einem Ansteuersignal einen ersten Schnittstellenzustand oder einen zweiten Schnittstellenzustand zu bewirken; und
- eine Ansteuersignalformungsschaltung (70), die ausgelegt ist, auf ein Steuersignal einer Steuereinheit hin das Ansteuersignal für die steuerbare Schaltanordnung (30) bereitzustellen, wobei die Ansteuersignalformungsschaltung (70) eine Flanken-Verlangsamungsschaltung (80) aufweist, die ausgelegt ist, um selektiv Flanken einer ersten Flankenrichtung des Ansteuersignals zu verlangsamen,
**gekennzeichnet dadurch, dass**
- die Flanken-Verlangsamungsschaltung (80) ein erstes RC-Glied (85) aufweist, und
- die Ansteuersignalformungsschaltung (70) ferner einen Koppelschalter (72) aufweist, über den das erste RC-Glied (85) mit einem Ansteuersignalknoten (75) gekoppelt ist, wobei der Ansteuersignalknoten (75) mit einem Ansteueranschluss (30a) der steuerbaren Schaltanordnung (30) gekoppelt ist,
- wobei der Koppelschalter (72) ausgebildet ist, die Flanken-Verlangsamungsschaltung (80), in Abhängigkeit einer Spannungsdifferenz zwischen einer Spannung an dem Ansteuersignalknoten (75) und einer an dem Koppelschalter-Anschluss des ersten RC-Glieds (85) und an dem Koppelschalter (72) anliegenden Spannung, über den Ansteuersignalknoten (75) an die steuerbare Schaltanordnung (30) zu koppeln oder von der steuerbaren Schaltanordnung (30) zu entkoppeln.

2. Schnittstellenschaltung gemäß Anspruch 1, wobei der Koppelschalter (72) als Diode ausgelegt ist, die bei einer an der Diode anliegenden Spannung, die größer oder gleich einer Diodendurchlassspannung der Diode ist, die Flanken-Verlangsamungsschaltung (80) an die steuerbare Schaltanordnung (30) koppelt, und bei einer an der Diode anliegenden Spannung, die kleiner als eine Diodendurchlassspannung der Diode ist, die Flanken-Verlangsamungsschaltung (80) im Wesentlichen von der steuerbaren Schaltanordnung (30) entkoppelt.

3. Schnittstellenschaltung (100) gemäß Anspruch 1 oder Anspruch 2, wobei die steuerbare Schaltanordnung (30) eine Schwellenspannung zum Durchsteuern der steuerbaren Schaltanordnung (30) aufweist, die größer ist als eine Koppelschwellenspannung des Koppelschalters (85) zum Koppeln der Flanken-Verlangsamungsschaltung (80) an die steuerbare Schaltanordnung (30).

4. Schnittstellenschaltung (100) gemäß einem der vorhergehenden Ansprüche, wobei die Flanken-Verlangsamungsschaltung (80) ein erstes RC-Glied (85) aufweist, das so mit einem Ansteuersignalknoten (75) gekoppelt ist, dass das erste RC-Glied (85) bei einer Flanke der ersten Flankenrichtung des Ansteuersignals wirksam ist, um eine Veränderung eines Potentials des an dem Ansteuersignalknoten (75) anliegenden Ansteuersignals zu verlangsamen, und dass das erste RC-Glied (85) bei einer Flanke der zweiten Flankenrichtung des Ansteuersignals im Wesentlichen von dem Ansteuersignalknoten (75) entkoppelt ist.

5. Schnittstellenschaltung (100) gemäß Anspruch 4, wobei die Ansteuersignal-Formschaltung (70) ein zweites RC-Glied (74) aufweist, das so mit dem Ansteuersignalknoten (75) gekoppelt ist, dass das erste RC-Glied (85) und das zweite RC-Glied (74) bei einer Flanke der ersten Flankenrichtung des Ansteuersignals wirksam ist, um eine Veränderung eines Potentials des Ansteuersignals zu verlangsamen, und bei einer Flanke der zweiten Flankenrichtung des Ansteuersignals eine Flankensteilheit im Wesentlichen von dem zweiten RC-Glied (74) beeinflusst wird und von dem ersten RC-Glied (85) im Wesentlichen unbeeinflusst bleibt.

6. Schnittstellenschaltung (100) gemäß Anspruch 5, wobei eine RC-Zeitkonstante des zweiten RC-Gliedes (74) so ausgelegt ist, um eine vorbestimmte Flankensteilheit einer Flanke der zweiten Flankenrichtung zu erzielen und wobei eine RC-Zeitkonstante des ersten RC-Gliedes (85) so ausgelegt ist, um zusammen mit der RC-Zeitkonstante des zweiten RC-Gliedes (74) eine vorbestimmte Flankensteilheit einer Flanke der ersten Flankenrichtung zu erzielen.

7. Schnittstellenschaltung (100) gemäß einem der vorhergehenden Ansprüche, wobei die steuerbare Schaltanordnung als Einzeltransistor ausgebildet ist.

8. Schnittstellenschaltung (100) gemäß einem der Ansprüche 1 bis 7, wobei die steuerbare Schaltanordnung (30) als Darlingtonschaltung mit zumindest zwei Transistoren ausgebildet ist, und wobei die Darlingtonschaltung (30) einen in Abhängigkeit von dem Ansteuersignal steuerbaren ausgangsseitigen Strompfad (35) aufweist.

9. Schnittstellenschaltung (100) gemäß Anspruch 5, wobei die steuerbare Schaltanordnung (30) als Darlingtonschaltung mit zumindest zwei Transistoren (Q5, Q6) ausgebildet ist, und die Darlingtonschaltung (30) einen in Abhängigkeit von dem Ansteuersignal steuerbaren ausgangsseitigen Strompfad (35) aufweist, und wobei die Ansteuersignalformungsschaltung (70) ferner ein drittes RC-Glied (76) aufweist, und wobei das zweite RC-Glied (74) mit einem Steueranschluss eines eingangsseitigen Transistors (Q5) der Darlingtonschaltung (30) gekoppelt ist und das dritte RC-Glied (76) mit einem Steueranschluss eines ausgangsseitigen Transistors (Q6) der Darlingtonschaltung (30) gekoppelt ist.

10. Schnittstellenschaltung (100) gemäß Anspruch 8 oder 9, bei der die Darlingtonschaltung Bipolartransistoren aufweist, die eine Kollektor-Emitter-Spannungsfestigkeitt von zumindest 100 V, zumindest 600 V oder zumindest 1000 V aufweisen.

11. Schnittstellenschaltung (100) gemäß einem der vorhergehenden Ansprüche, die ferner eine Gleichrichterschaltung (20) aufweist, die ausgebildet ist, um in Abhängigkeit einer an Gleichrichtereingangsanschlüssen (20a, 20b) anliegende Gleichrichtereingangsspannung an Gleichtrichterausgangsanschlüssen (20c, 20d) eine gleichgerichtete Gleichrichterausgangsspannung bereitzustellen, und wobei die steuerbare Schaltanordnung (30) zwischen die Gleichrichterausgangsanschlüssen (20c, 20d) gekoppelt ist, so dass in Abhängigkeit von dem Ansteuersignal an den Gleichrichtereingangsanschlüssen (20a, 20b) der erste Schnittstellenzustand oder der zweite Schnittstellenzustand bewirkbar ist.

12. Schnittstellenschaltung (100) gemäß Anspruch 11, die ferner eine Stromquelle (40) aufweist, die zwischen einen ersten Gleichrichterausgangsanschluss (20c) und einem Ansteueranschluss (30a) der steuerbaren Schaltanordnung (30) gekoppelt ist.

13. Schnittstellenschaltung (100) gemäß Anspruch 12, die ferner einen Knoten (45) aufweist, der elektrisch zwischen die Stromquelle (40), den Ansteueranschluss (30a) der steuerbaren Schaltanordnung (30) und eine Schaltungsanordnung zur Spannungsbegrenzung (50) gekoppelt ist.

14. Schnittstellenschaltung (100) gemäß Anspruch 13, wobei die Schaltungsanordnung zur Spannungsbegrenzung (50) eine in Sperrrichtung angeordnete Zenerdiode (Z2) aufweist.

15. Schnittstellenschaltung (100) gemäß Anspruch 13, wobei der Knoten (45) ferner mit einem Optokoppler (60) zum Empfang eines Steuersignals gekoppelt ist, und wobei der Optokoppler (60) mit einem Ansteueranschluss (30a) der steuerbaren Schaltanordnung (30) gekoppelt ist, wobei die steuerbare Schaltanordnung (30) als Darlingtonschaltung mit zumindest zwei Transistoren (Q5, Q6) ausgebildet ist und der Ansteueranschluss (30a) mit dem eingangsseitigen Transistor (Q5) der Darlingtonschaltung gekoppelt ist.

16. Schnittstellenschaltung (100) gemäß einem der vorhergehenden Ansprüche, wobei die Schnittstellenschaltung ausgebildet ist Daten- und/oder Steuersignale zwischen einem Bussystem (15) und einer Steuereinheit (µC), zwischen die die Schnittstellenschaltung (100) gekoppelt ist, auszutauschen.

17. Betriebsgerät für Leuchtmittel, insbesondere Gasentladungslampen, LEDs und/oder OLEDs, oder Bus-Zentraleinheit mit einer Schnittstellenschaltung (100) gemäß einem der Ansprüche 1 bis 16.

18. Beleuchtungssystem (300) zur Steuerung von Leuchtmitteln (210) mit einer zentralen Steuereinheit (310) zur Steuerung eines Betriebszustandes von Leuchtmittel und zumindest mit einem Betriebsgerät für Leuchtmittel gemäß Anspruch 17, wobei die zentrale Steuereinheit (310) und das elektrische Vorschaltgerät (200) für Leuchtmittel über ein Bussystem (15) zur Übertragung von Daten- und/oder Steuersignalen elektrisch gekoppelt sind.

19. Beleuchtungssystem (300) zur Steuerung von Leuchtmitteln gemäß Anspruch 18, wobei das Bussystem (15) ein DALI-Bussystem ist, das ausgebildet ist Daten- und/oder Steuersignale nach dem DALI-Protokoll zwischen der zentralen Steuereinheit (310) und dem zumindest einem Betriebsgerät zu übertragen.

20. Verfahren zur Beeinflussung der Flankensteilheit eines Ansteuersignals für eine steuerbare Schaltanordnung im Sendezweig einer Schnittstellenschaltung, die ausgelegt ist, um in Abhängigkeit von dem Ansteuersignal einen ersten Schnittstellenzustand oder einen zweiten Schnittstellenzustand an einer Schnittstellenschaltung zu bewirken, mit folgenden Schritten:
- Bereitstellen (400) eines Ansteuersignals für die steuerbare Schaltanordnung in Abhängigkeit von einem Steuersignal einer Ansteuersignalformungsschaltung; wobei das Bereitstellen ein Verlangsamen (410) einer Flanke einer ersten Flankenrichtung des Ansteuersignals mit einer Flanken-Verlangsamungsschaltung der Ansteuersignalformungsschaltung; und
- ein im Wesentlichen Unbeeinflusstlassen einer Flanke einer zweiten Flankenrichtung des Ansteuersignals umfasst, wobei
- der Schritt des Verlangsamens (410) einer Flanke einer ersten Flankenrichtung des Ansteuersignals ein Koppeln eines RC-Gliedes an die steuerbare Schaltanordnung aufweist, und wobei dass im Wesentlichen Unbeeinflusstlassen einer Flanke einer zweiten Flankenrichtung des Ansteuersignals ein Entkoppeln des RC-Gliedes von der steuerbaren Schaltanordnung, aufweist.

## Claims

1. Interface circuit (100) having a transmission path comprising:
- a controllable switching arrangement (30), which is designed to switch to a first or a second interface state in response to a control signal interface state; and
- a trigger signal shaping circuit (70) designed to provide the trigger signal for the controllable switching arrangement (30) in response to a control signal from a control unit, wherein the trigger signal shaping circuit (70) comprises a edge deceleration circuit (80) designed to slow selected edges in a first edge direction of the trigger signal,
**characterized in that**
- the edge deceleration circuit (80) has a first RC element (85), and
- the trigger signal shaping circuit (70) further comprises a coupling switch (72) via which the first RC element (85) is coupled to a trigger signal node (75), wherein the trigger signal node (75) is coupled to a trigger terminal (30a) of the controllable switching arrangement (30),
- wherein the coupling switch (72) is designed to couple the edge deceleration circuit (80) to the controllable switching arrangement (30), in response to a voltage difference between a voltage at the trigger signal node (75) and a voltage at the coupling switch terminals of the first RC element (85) and the voltage at the coupling switch (72) via the trigger signal node (75), or to decouple it from the controllable switching arrangement (30).

2. Interface circuit (100) according to claim 1, wherein the coupling switch (72) is in the form of a diode, when a voltage applied to the diode is greater than or equal to a diode forward bias of the diode, couples the edge deceleration circuit (80) to the controllable switching arrangement (30), and wherein a voltage applied to the diode that is less than the diode forward voltage of the diode, substantially decouples the edge deceleration circuit (80) from the controllable switching arrangement (30).

3. Interface circuit (100) according to claim 1 or claim 2, wherein the controllable switching arrangement (30) has a threshold voltage for controlling the controllable switching arrangement (30) which is greater than a coupling threshold voltage of the coupling switch (85) for coupling the edge deceleration circuit (80) to the controllable switching arrangement (30).

4. Interface circuit (100) according to any one of the preceding claims, wherein the edge deceleration circuit (80) comprises a first RC element (85) coupled to a trigger signal node (75), so that the first RC element (85) is operative at an edge in the first edge direction of the trigger signal in order to slow down a change in a potential of the trigger signal applied to the trigger signal node (75), and that the first RC element (85) at an edge in the second edge direction of the trigger signal is substantially decoupled from the trigger signal node (75).

5. Interface circuit (100) according to claim 4, wherein the trigger signal shaping circuit (70) comprises a second RC element (74) coupled to the trigger signal node (75) so that the first RC element (85) and the second RC element (74) is effective at an edge in the first edge direction of the trigger signal, in order to slow down a change of a potential of the trigger signal, while, at an edge in the second edge direction of the trigger signal, an edge steepness is substantially influenced by the second RC element (74) and remains substantially unaffected by the first RC element (85).

6. Interface circuit (100) according to claim 5, wherein an RC time constant of the second RC element (74) is designed to achieve a predetermined edge steepness of an edge in the second edge direction, and wherein an RC time constant of the first RC element (85) is designed to achieve a predetermined edge steepness of an edge in the first edge direction together with the RC time constant of the second re-member (74).

7. Interface circuit (100) according to one of the preceding claims, wherein the controllable switching arrangement is designed as a single transistor.

8. Interface circuit according to claims 1 to 7, wherein the switching arrangement (30) is in the form of a Darlington circuit with at least two transistors, and wherein the Darlington circuit (30) comprises an output side current path (35) that is in controllable dependence on the trigger signal.

9. Interface circuit (100) according to claim 5, wherein the controllable switching arrangement (30) is in the form of a Darlington circuit with at least two transistors (Q5, Q6), and the Darlington circuit (30) comprises an output side current path (35) that is in controllable dependence on the trigger signal, wherein the trigger signal shaping circuit (70) further comprises a third RC element (76), and wherein the second RC element (74) is coupled to a control terminal of an input side transistor (Q5) of the Darlington circuit (30), while the third RC element (76) is coupled to a control terminal of an output side transistor (Q6) of the Darlington circuit (30).

10. Interface circuit (100) according to claim 8 or 9, wherein the Darlington circuit comprises bipolar transistors having a collector-emitter voltage rating of at least 100V, at least 600V, or at least 1000V.

11. Interface circuit (100) according to one of the preceding claims, wherein it further comprises a rectifier circuit (20) which is designed in order to generate a rectified rectifier output voltage at the rectifier output terminals (20c, 20d) as a function of the rectifier input voltage at the rectifier input terminals (20a, 20b), and wherein the controllable switching arrangement (30) is coupled between the rectifier output terminals (20c, 20d) so that the first interface state or the second interface state may be switched as a function of the trigger signal at the rectifier input terminals (20a, 20b).

12. Interface circuit (100) according to claim 11 which further comprises a current source (40) that is coupled between a first rectifier output terminal (20c) and a trigger terminal (30a) of the controllable switching arrangement (30).

13. Interface circuit (100) according to claim 12 which further comprises a node (45) that is electrically coupled between the power source (40), the trigger terminal (30a) of the controllable circuit (30), and a switching arrangement for limiting the voltage (50).

14. Interface circuit (100) according to claim 13, wherein the circuit arrangement for limiting the voltage (50) has a reverse-biased zener diode (Z2).

15. Interface circuit (100) according to claim 13, wherein the node (45) is further coupled with an optocoupler (60) to receive a control signal, and wherein the optocoupler (60) is coupled to a trigger terminal (30a) of the controllable switching arrangement (30), wherein the controllable switching arrangement (30) is in the form of a Darlington circuit with at least two transistors (Q5, Q6), and the trigger terminal (30a) is coupled to the input-side transistor (Q5) of the Darlington circuit.

16. Interface circuit (100) according to one of the preceding claims, wherein the interface circuit is designed to exchange data and/or control signals between a bus system (15) and a control unit (µC), between which the interface circuit (100) is coupled.

17. Operating device for luminaires, in particular gas discharge lamps, LEDs and/or OLEDs, or a bus central unit with an interface circuit (100) according to one of the claims 1 to 16.

18. Lighting system (300) for controlling luminaires (210) with a central control unit (310) for controlling an operating state of luminaires, and with at least one operating device for luminaires according to claim 17, wherein the central control unit (310) and the electrical ballast unit (200) for luminaires are electrically coupled via a bus system (15) for transmitting data and/or control signals.

19. Lighting system (300) for controlling luminaires according to claim 18, wherein the bus system (15) is a DALI bus system, which is designed to transfer data and/or control signals between the central control unit (310) and the at least one ballast unit according to the DALI protocol.

20. Method for influencing the edge steepness of a trigger signal for a controllable switching arrangement in the transmit path of an interface circuit, which is designed to switch a first interface state or a second interface state in an interface circuit as a function of the trigger signal, and comprises the following steps:
- provision (400) of a trigger signal for the controllable switching arrangement as a function of a control signal from a trigger signal shaping circuit; wherein the provision causes a slowing (410) of an edge in a first edge direction of the trigger signal via an edge deceleration circuit of the trigger signal shaping circuit; which comprises
- a substantially uninfluenced edge in a second edge direction of the trigger signal, wherein
- the deceleration step (410) of an edge in a first edge direction of the trigger signal comprises coupling of an RC element to the controllable switching arrangement, wherein the substantial leaving of an edge in a second edge direction of the trigger signal uninfluenced leads to uncoupling of the RC element from the controllable switching arrangement.

## Revendications

1. Circuit d'interface (100) avec une branche d'émission qui comprend :
- un circuit contrôlable (30) qui est conçu pour activer, en fonction d'un signal de contrôle, un premier état d'interface ou un deuxième état d'interface ; et
- un circuit de formation de signal de contrôle (70) qui est conçu pour générer, lors d'un signal d'une unité de commande, le signal de contrôle pour le circuit contrôlable (30), le circuit de formation de signal de contrôle (70) comprenant un circuit de ralentissement des flancs (80), qui est conçu pour ralentir de manière sélective les flancs dans une première direction de flancs du signal de contrôle,
**caractérisé en ce que**
- le circuit de ralentissement des flancs (80) comprend un premier organe RC (85) et
- le circuit de formation de signal de contrôle (70) comprend en outre un commutateur de couplage (72) par l'intermédiaire duquel le premier organe RC (85) est couplé avec un noeud de signal de contrôle (75), le noeud de signal de contrôle (75) étant couplé avec une borne de contrôle (30a) du circuit contrôlable (30),
- le commutateur de couplage (72) étant conçu pour coupler ou découpler le circuit de ralentissement des flancs (80), par l'intermédiaire du noeud de signal de contrôle (75), au circuit contrôlable (30) ou de le découpler du circuit contrôlable (30), en fonction de la différence de tension entre une tension appliquée au noeud de signal de contrôle (75) et une tension appliquée à la borne de commutateur de couplage du premier organe RC (85) et au commutateur de couplage (72).

2. Circuit d'interface selon la revendication 1, le commutateur de couplage (72) étant conçu comme une diode qui, dans le cas d'une tension appliquée à la diode, qui est supérieure ou égale à une tension directe de la diode, couple le circuit de ralentissement des flancs (80) au circuit contrôlable (30) et, dans le cas d'une tension appliquée à la diode, qui est inférieure à une tension directe de la diode, découple le circuit de ralentissement des flancs (80) globalement du circuit contrôlable (30).

3. Circuit d'interface (100) selon la revendication 1 ou la revendication 2, le circuit contrôlable (30) présentant une tension de seuil pour l'activation du circuit contrôlable (30), qui est supérieure à une tension de seuil de couplage du commutateur de couplage (85) pour le couplage du circuit de ralentissement des flancs (80) au circuit contrôlable (30).

4. Circuit d'interface (100) selon l'une des revendications précédentes, le circuit de ralentissement des flancs (80) comprenant un premier organe RC (85) qui est couplé avec un noeud de signal de contrôle (75) de façon à ce que le premier organe RC (85) soit actif au niveau d'un flanc de la première direction de flanc du signal de commande, afin de ralentir une variation d'un potentiel du signal de contrôle appliqué au noeud de signal de contrôle (75), et en ce que le premier organe RC (85) est découplé globalement du noeud de signal de contrôle (75) au niveau d'un flanc de la deuxième direction de flanc du signal de contrôle.

5. Circuit d'interface (100) selon la revendication 4, le circuit de formation du signal de contrôle (70) comprend un deuxième organe RC (74), qui est couplé avec le lnoeud de signal de contrôle (75) de façon à ce que le premier organe RC (85) et le deuxième organe RC (74) soient actifs au niveau d'un flanc de la première direction de flanc du signal de contrôle, afin de ralentir une variation d'un potentiel du signal de contrôle et, au niveau d'un flanc de la deuxième direction de flanc du signal de contrôle, une pente de flanc est globalement influencée par le deuxième organe RC (74) et reste globalement non influencée par le premier organe RC (85).

6. Circuit d'interface (100) selon la revendication 5, une constante de temps RC du deuxième organe RC (74) étant conçue pour obtenir une pente de flanc prédéterminée d'un flanc de la deuxième direction de flanc et une constante de temps RC du premier organe RC (85) étant conçue pour obtenir, conjointement avec la constante de temps RC du deuxième organe RC (74), une pente de flanc prédéterminée d'un flanc de la première direction de flanc.

7. Circuit d'interface (100) selon l'une des revendications précédentes, le circuit contrôlable étant conçu comme un simple transistor.

8. Circuit d'interface (100) selon l'une des revendications 1 à 7, le circuit contrôlable (30) étant conçu comme un circuit Darlington avec au moins deux transistors et le circuit Darlington (30) comprenant un trajet de courant côté sortie (35) pouvant être contrôlé par le signal de contrôle.

9. Circuit d'interface (100) selon la revendication 5, le circuit contrôlable (30) étant conçu comme un circuit Darlington avec au moins deux transistors (Q5, Q6) et le circuit Darlington (30) comprenant un trajet de courant côté sortie (35) pouvant être contrôlé en fonction du signal de contrôle et le circuit de formation du signal de contrôlable (70) comprenant en outre un troisième organe RC (76) et le deuxième organe RC (74) étant couplé avec une borne de contrôle d'un transistor côté entrée (Q5) du circuit Darlington (30) et le troisième organe RC (76) étant couplé avec une borne de contrôle d'un transistor côté sortie (Q6) du circuit Darlington (30).

10. Circuit d'interface (100) selon la revendication 8 ou la revendication 9, dans lequel le circuit Darlington comprend des transistors bipolaires qui présentent une rigidité diélectrique collecteur-émetteur d'au moins 100 V, d'au moins 600 V ou d'au moins 1000 V.

11. Circuit d'interface (100) selon l'une des revendications précédentes, qui comprend en outre un circuit redresseur (20) qui est conçu pour générer, en fonction d'une tension d'entrée de redresseur appliquée à des bornes d'entrée du redresseur (20a, 20b), au niveau des bornes de sortie du redresseur (20ac, 20d), une tension de sortie de redresseur redressée et le circuit contrôlable (30) étant couplé entre les bornes de sortie du redresseur (20a, 20b), de façon à ce que le premier état d'interface ou le deuxième état d'interface puisse être activé en fonction du signal de contrôle au niveau des bornes d'entrée du redresseur (20a, 20b).

12. Circuit d'interface (100) selon la revendication 11, qui comprend en outre au moins une source de courant (40), qui est couplée entre une borne de sortie du redresseur (20c) et une borne de contrôle (30a) du circuit contrôlable (30).

13. Circuit d'interface (100) selon la revendication 12, qui comprend en outre un noeud (45) qui est couplé électriquement entre la source de courant (40), la borne de contrôle (30a) du circuit contrôlable (30) et un circuit pour la limitation de la tension (50).

14. Circuit d'interface (100) selon la revendication 13, le circuit pour la limitation de la tension (50) comprenant une diode Zener (Z2) disposée dans le sens de blocage.

15. Circuit d'interface (100) selon la revendication 13, le noeud (45) étant couplé en outre avec un optocoupleur (60) pour la réception d'un signal de contrôle, et l'optocoupleur (60) étant couplé avec une borne de contrôle (30a) du circuit de contrôle (30), le circuit de contrôle (30) étant conçu comme un circuit Darlington avec au moins deux transistors (Q5, Q6) et la borne de contrôle (30a) étant couplée avec le transistor côté entrée (Q5) du circuit Darlington.

16. Circuit d'interface (100) selon l'une des revendications précédentes, le circuit d'interface étant conçu pour échanger des données et/ou des signaux de commande entre un système de bus (15) et une unité de commande (µC), entre lesquels le circuit d'interface (100) est couplé.

17. Appareil d'actionnement pour des moyens d'éclairage, plus particulièrement des lampes à décharge de gaz, des LED et/ou des OLED, ou unité centrale à bus avec un circuit d'interface (100) selon l'une des revendications 1 à 16.

18. Système d'éclairage (300) pour le contrôle de moyens d'éclairage (210) avec une unité de commande centrale (310) pour la commande d'un état de fonctionnement de moyens d'éclairage et au moins avec un appareil d'actionnement pour des moyens d'éclairage selon la revendication 17, l'unité de commande centrale (310) et le ballast électrique (200) pour moyens d'éclairage étant couplés électriquement par l'intermédiaire d'un système de bus (15) pour la transmission de données et/ou de signaux de commande.

19. Système d'éclairage (300) pour le contrôle de moyens d'éclairage selon la revendication 18, le système de bus (15) étant un système de bus DALI, qui est conçu pour transmettre des données et/ou des signaux de commande selon le protocole DALI entre l'unité de commande centrale (310) et l'au moins un appareil d'actionnement.

20. Procédé de contrôle de la pente des flancs d'un signal de contrôle pour un circuit contrôlable dans la branche d'émission d'un circuit d'interface, qui est conçu pour activer, en fonction du signal de contrôle, un premier état d'interface ou un deuxième état d'interface au niveau d'un circuit d'interface, avec les étapes suivantes :
- génération (400) d'un signal de contrôle pour le circuit contrôlable en fonction d'un signal de contrôle d'un circuit de formation de signal de contrôle ; la génération comprenant un ralentissement (410) d'un flanc d'une première direction de flanc du signal de contrôle avec un circuit de ralentissement de flancs du circuit de formation de signal de contrôle ; et
- le fait de laisser globalement non influencé un flanc d'une deuxième direction de flanc du signal de contrôle,
- l'étape de ralentissement (410) d'un flanc d'une première direction de flanc du signal de contrôle comprenant un couplage d'un organe RC au circuit contrôlable et le fait de laisser globalement non influencé un flanc d'une deuxième direction de flanc du signal de contrôle comprenant un découplage de l'organe RC du circuit contrôlable.
